# EUROPEAN PATENT APPLICATION

(11) **EP 2 503 681 A1**
(43) Date of publication of application: **26.09.2012**
(21) Application number: 09851455.7
(22) Date of filing: 19.11.2009
(51) Int. Cl.: H02N 2/00, B81B 3/00, G02B 26/08, G02B 26/10

(54) **DRIVE APPARATUS**

(71) Applicant: Pioneer Corporation, Kanagawa 212-0031 (JP)
(72) Inventor: SUZUKI, Jun, Tsurugashima-shi Saitama 350-2288 (JP)
(74) Representative: Viering, Jentschura & Partner
(86) International application number: PCT/JP2009/069638
(87) International publication number: WO 2011/061833

(57) **Abstract**

A driving apparatus (100) is provided with: a base part (110); a driven part (130) capable of rotating; an elastic part (120); and an applying part (140) for applying to the base part microvibration for rotating the driven part around an axis along one direction (Y-axis) such that the driven part rotates while resonating at a resonance frequency determined by the elastic part and the driven part.

## Description

### Technical Field

The present invention relates to a driving apparatus such as, for example, a MEMS scanner for rotating a driven object such as a mirror.

### Background Art

In various technical fields such as, for example, a display, a printing apparatus, precision measurement, precision processing, and information recording-reproduction, research on a micro electro mechanical system (MEMS) device manufactured by a semiconductor fabrication technology is actively progressing. As the MEMS device as described above, a mirror driving apparatus having a microscopic structure (a light scanner or a MEMS scanner) attracts attention, for example, in a display field in which images are displayed by scanning a predetermined screen area with which enters from a light source, or in a scanning field in which a predetermined screen area is scanned with light and image information is read by receiving reflected light.

There is known a mirror driving apparatus which is provided with: a fixed main body to be a base; a mirror capable of rotating around a predetermined central axis; and a torsion bar (a torsion member) for connecting or joining the main body and the mirror (refer to a patent document 1).

### Patent Document

Patent document 1: Published Japanese translation of a PCT application (Tokuhyo) No. 2007-522529

### Disclosure of Invention

### Subject to be Solved by the Invention

In the mirror driving apparatus having such a configuration, it is general that the mirror is driven by using a coil and a magnet. As one example of such a configuration, for example, there is listed a configuration in which the coil is directly attached to the mirror. In this case, due to an interaction between a magnetic field of the magnet and a magnetic field generated by applying an electric current to the coil, a force in a rotational direction is applied to the mirror, resulting in the rotation of the mirror. Moreover, in the aforementioned patent document 1, there is adopted such a configuration that the coil and the magnet are disposed to cause a distortion in a torsional direction (in other words, a direction of an axis of the rotation of the mirror) to the torsion bar. In this case, due to the interaction between the magnetic field of the magnet and the magnetic field generated by applying the electric current to the coil, the torsion bar is distorted in the torsional direction, and the distortion in the torsional direction of the torsion bar causes the rotation of the mirror.

For the conventional mirror driving apparatus as described above, it is therefore an object of the present invention to provide a driving apparatus (i.e. MEMS scanner) capable of driving the mirror (or driven object which rotates) by using the action of a force other than a force directly causing the rotation of the mirror or other than a force directly causing the distortion in the torsional direction of the torsion bar (by using a force other than a force acting in the rotational direction of the mirror).

The above object of the present invention can be achieved by a driving apparatus provided with: a base part; a driven part capable of rotating; an elastic part which connects the base part and the driven part and which has elasticity for rotating the driven part around an axis along one direction; and an applying part for applying, to the base part, microvibration for rotating the driven part such that the driven part rotates while resonating around the axis along the one direction at a resonance frequency determined by the elastic part and the driven part.

These operation and other advantages of the present invention will become more apparent from the embodiment explained below.

### Brief Description of Drawings

[FIG. 1] FIG. 1 is a plan view conceptually showing a configuration of a driving apparatus in a first example.
[FIG. 2] FIG. 2 is a plan view conceptually showing an aspect of operation performed by the driving apparatus in the first example.
[FIG. 3] FIG. 3 is a plan view for explaining a non-directional force caused by microvibration applied from a driving source part.
[FIG. 4] FIG. 4 is a plan view conceptually showing a configuration of a driving apparatus in a second example.
[FIG. 5] FIGs. 5 are plan views conceptually showing an aspect of operation performed by the driving apparatus in the second example.
[FIG. 6] FIG. 6 is a plan view for explaining a non-directional force caused by microvibration applied from a driving source part.
[FIG. 7] FIGs. 7 are graphs showing experimental results.
[FIG. 8] FIG. 8 is a plan view conceptually showing one example of a configuration of a driving apparatus in a third example.
[FIG. 9] FIG. 9 is a plan view conceptually showing another example of the configuration of the driving apparatus in the third example.
[FIG. 10] FIG. 10 is a plan view conceptually showing a configuration of a driving apparatus in a fourth example.
[FIG. 11] FIG. 11 is a plan view conceptually showing another configuration of the driving apparatus in the fourth example.

### Best Mode for Carrying Out the Invention

Hereinafter, as the best mode for carrying out the present invention, an explanation will be given to an embodiment of the driving apparatus in order.

A driving apparatus in the embodiment is provided with: a base part; a driven part capable of rotating; an elastic part which connects the base part and the driven part and which has elasticity for rotating the driven part around an axis along one direction; and an applying part for applying, to the base part, microvibration for rotating the driven part such that the driven part rotates while resonating around the axis along the one direction at a resonance frequency determined by the elastic part and the driven part.

According to the driving apparatus in the embodiment, the base part which is a foundation and the driven part (e.g. a mirror described later, etc.) which is disposed so as to rotate are connected directly or indirectly by the elastic part (e.g. a torsion bar described later, etc.) having the elasticity. The driven part is driven so as to rotate around the axis along the one direction by the elasticity of the elastic part (e.g. the elasticity capable of rotating the driven part around the axis along the one direction).

In the driving apparatus in the embodiment, in particular, by the operation of the applying part, the microvibration is applied such that the driven part rotates while resonating around the axis along the one direction at the resonance frequency determined by the elastic part and the driven part. At this time, the applying part in the embodiment applies the microvibration to the base part such that the microvibration is propagated in the inside of a structure which is the base part. That is, the applying part in the embodiment applies the microvibration which is propagated in the inside of the structure, as excitation energy (in other words, pulsed energy) for rotating the driven part, instead of applying a force directly distorting or twisting the base part. In other words, the applying part in the embodiment applies the microvibration which is propagated as energy (in other words, as energy for developing a force of "vibration" without changing the force to vibration) in the inside of the structure, as wave-energy for rotating the driven part. The microvibration (in other words, wave-energy propagated in the inside of the structure) is a non-directional force at least when being propagated in the inside of the structure. In other words, the wave-energy propagated in the inside of the base part as the microvibration is propagated in an arbitrary direction in the inside of the base part. As a result, the microvibration is transmitted as the wave-energy from the structure such as, for example, the base part to the elastic part (and further from the base part via the elastic part to the driven part). After that, the microvibration (in other words, wave-energy) propagated in the inside of the structure vibrates the elastic part in a direction according to the elasticity of the elastic part or rotates the driven part around the axis along the direction according to the elasticity of the elastic part. In other words, the wave-energy can be extracted as vibration along all directions without limiting the direction of the microvibration. In other words, the wave-energy propagated in the inside of the base part can be extracted to the exterior in a form of vibration (more specifically, resonance), resulting in the rotation of the driven part. Incidentally, the wave-energy can be extracted to the exterior as a sound; however, the sound generated in this case has a different sound generation principle, in comparison with that of a sound obtained by a so-called piston motion.

Here, if the driven part is driven so as to rotate by applying a so-called directional force (e.g. if the base part is greatly distorted or twisted along a rotational direction of the driven part and the distortion is directly applied to the elastic part and the driven part to rotate the driven part), the applying part needs to apply a directional force for rotating the driven part around the axis along the one direction (i.e. a directional force for distorting or twisting the structure such as the base part along the rotational direction which is around the axis along the one direction). Thus, the placement position of the applying part needs to be appropriately set such that the directional force can be applied. In other words, if the directional force is applied, the placement position of the applying part is limited depending on a direction of acting the force.

In the embodiment, however, since the non-directional force caused by the microvibration is applied, the placement position of the applying part is no longer limited. In other words, the application of the non-directional force caused by the microvibration does not cause such a situation that the placement position of the applying part is limited depending on the rotational direction of the driven part. That is, regardless of the placement position of the applying part, the microvibration (i.e. the non-directional force) applied from the applying part allows the driven part to rotate around the axis along the one direction, using the elasticity of the elastic part. This makes it possible to relatively increase the degree of freedom in the design of the driving apparatus.

In one aspect of the driving apparatus in the embodiment, the microvibration is non-direcitonal microvibration or anisotropic microvibration as non-directional vibration energy.

According to this aspect, the wave-energy propagated in the inside of the base part as the non-directional microvibration or anisotropic microvibration can be propagated in an arbitrary direction in the inside of the base part. As a result, the wave-energy can be extracted as vibration along all directions without limiting the direction of the microvibration. In other words, the wave-energy propagated in the inside of the base part can be extracted to the exterior in a form of vibration (more specifically, resonance), resulting in the rotation of the driven part.

In another aspect of the driving apparatus in the embodiment, the applying part applies the microvibration which is caused by a force acting along a direction that is different from a direction of the rotation around the axis along the one direction.

According to this aspect, when applying the microvibration, the applying part firstly generates the force acting in the direction different from the direction of the rotation around the axis along the one direction (i.e. the direction of the rotation of the driven part). This force becomes the microvibration (in other words, wave-energy) and is applied to the base part, as explained in detail using the drawings later. In other words, it is possible to apply the microvibration caused by the force acting along the direction different from the direction of the rotation around the axis along the one direction (in other words, the microvibration or wave-energy caused by converting the force). Therefore, it is possible to preferably receive the various effects described above.

In another aspect of the driving apparatus in the embodiment, the applying part applies the microvibration which is caused by a force acting along a direction along a surface of the driven part which is in a static condition.

According to this aspect, when applying the microvibration, the applying part firstly generates the force acting along the direction along the surface of the driven part (i.e. the force acting along an in-plane direction) which is in the static condition (in other words, in an initial placement condition). This force becomes the microvibration (in other words, wave-energy) and is applied to the base part, as explained in detail using the drawings later. In other words, it is possible to apply the microvibration caused by the force acting along the direction along the surface of the driven part which is in the static condition (in other words, the microvibration or wave-energy caused by converting the force). Therefore, it is possible to preferably receive the various effects described above.

In another aspect of the driving apparatus in the embodiment, the elastic part has elasticity for rotating the driven part around an axis along another direction which is different from the one direction, and the applying part applies, to the base part, the microvibration for rotating the driven part such that the driven part rotates while resonating around the axis along the one direction at the resonance frequency determined by the elastic part and the driven part and for rotating the driven part such that the driven part rotates while resonating around the axis along the another direction at a resonance frequency determined by the elastic part and a suspended part including the driven part.

According to this aspect, the driven part is driven so as to rotate around the axis along the one direction and is driven so as to rotate around the axis along the another direction by the elasticity of the elastic part (e.g. the elasticity capable of rotating the driven part around the axis along the one direction and the elasticity capable of rotating the driven part around the axis along the another direction). In other words, the driving apparatus in this aspect can perform biaxial rotational drive of the driven part. Incidentally, it is obvious that multiaxial rotational drive which is biaxial or more may be performed.

In this aspect, in particular, by the operation of the applying part, the microvibration is applied such that the driven part (in other words, the suspended part including the driven part) rotates while resonating around the axis along the another direction at the resonance frequency determined by the elastic part (more specifically, a first elastic part for suspending a second base part detailed later) and the suspended part including the driven part (more specifically, the suspended part which is a structure for suspending the driven part and the suspended part which is a structure composed of the driven part, the second base part and a second elastic part detailed later). More specifically, by the operation of the applying part, the microvibration is applied such that the driven part (in other words, the suspended part including the driven part) rotates while resonating around the axis along the another direction at the resonance frequency determined by the inertia moment around the axis along the another direction of the suspended part including the driven part (more specifically, the suspended part which is the structure for suspending the driven part and the suspended part which is the structure composed of the driven part, the second base part, and the second elastic part detailed later) and a torsion spring constant of the elastic part (more specifically, the first elastic part detailed later). At the same time, the microvibration allows the driven part to rotate while resonating around the axis along the one direction at the resonance frequency determined by the elastic part (more specifically, the second elastic part for suspending the driven part detailed later) and the driven part. More specifically, the microvibration allows the driven part to rotate while resonating around the axis along the one direction at the resonance frequency determined by the inertia moment around the axis along the one direction of the driven part and the torsion spring constant of the elastic part (more specifically, the second elastic part detailed later). In other words, in this aspect, the microvibration for performing the biaxial rotational drive of the driven part is applied from the same applying part (in other words, a single applying part).

Here, if the biaxial rotational drive of the driven part is performed by applying a so-called directional force (e.g. if the base part is greatly distorted or twisted along the rotational direction of the driven part and the distortion is directly applied to the elastic part and the driven part to perform the biaxial rotational drive of the driven part), one applying part needs to apply a directional force for rotating the driven part around the axis along the one direction (i.e. a directional force for distorting or twisting the structure such as the base part along the direction of the rotation around the axis along the one direction). Another applying part also needs to apply a directional force for rotating the driven part around the axis along the another direction (i.e. a directional force for distorting or twisting the structure such as the base part along the direction of the rotation around the axis along the another direction). That is, in the case where the biaxial rotational drive of the driven part is performed by applying the directional force, usually, the driving apparatus needs to be provided with two or more applying parts (in other words, two or more driving sources). In other words, in the case where the biaxial rotational drive of the driven part is performed by applying the directional force, only a force that acts along the one direction can be applied from one applying part, and thus, the driving apparatus needs to be provided with two or more applying parts (i.e. two or more driving sources).

In this aspect, however, the biaxial rotational drive of the driven part can be performed by applying the non-directional force caused by the microvibration. Here, since the non-directional force caused by the microvibration is applied, the microvibration applied from one applying part allows the driven part to rotate around the axis along the one direction and allows the driven part to rotate around the axis along the another direction, using the elasticity of the elastic part (i.e. the elasticity for rotating the driven part around the axis along the one direction and the elasticity for rotating the driven part around the axis along the another direction). In other words, in this aspect, even in the case of the biaxial rotational drive of the driven part, it is not always necessary to provide two applying parts. Thus, by using a single applying part (in other words, a single driving source), the microvibration for performing the biaxial rotational drive of the driven part can be applied.

In addition, even if a force acting along two directions can be applied from one applying part, in the case where the biaxial rotational drive of the driven part is performed by applying the directional force, it is eventually necessary to apply a force having components acting along the two directions (i.e. a directional component force for rotating the driven part around the axis along the one direction and a directional component force for rotating the driven part around the axis along the another direction). In this aspect, however, since the non-directional force caused by the microvibration is applied as the wave-energy, there is no need to apply the force with considering a direction of acting the force, which is also advantageous.

In another aspect of the driving apparatus in the embodiment, the base part comprises: a first base part; and a second base part at least partially surrounded by the first base part, the elastic part comprises: (i) a first elastic part which connects the first base part and the second base part and which has elasticity for rotating the second base part around the axis along the another direction; and (ii) a second elastic part which connects the second base part and the driven part and which has the elasticity for rotating the driven part around the axis along the one direction, and the applying part applies the microvibration for rotating the second base part such that the second base part rotates while resonating around the axis along the another direction at a resonance frequency determined by the first elastic part and a suspended part including the second base part and for rotating the driven part such that the driven part rotates while resonating around the axis along the one direction at a resonance frequency determined by the second elastic part and the driven part.

According to this aspect, the driven part is driven so as to rotate around the axis along the one direction and is driven so as to rotate around the axis along the another direction, by the elasticity of the elastic part (e.g. the elasticity capable of rotating the driven part around the axis along the one direction and the elasticity capable of rotating the driven part around the axis along the another direction). More specifically, the second base part can be rotated around the axis along the another direction by using the elasticity of the first elastic part, and the driven part can be rotated around the axis along the one direction using the elasticity of the second elastic part. Here, since the driven part is connected to the second base part via the second elastic part, the rotation of the second base part around the axis along the another direction results in the rotation of the driven part around the axis along the another direction. In other words, the driving apparatus in this aspect can perform the biaxial rotational drive of the driven part. Incidentally, it is obvious that multiaxial rotational drive which is biaxial or more may be performed.

In this aspect, in particular, by the operation of the applying part, the microvibration is applied such that the second base part (in other words, the driven part supported by the second base part) rotates while resonating around the axis along the another direction at the resonance frequency determined by the first elastic part and the suspended part including the second base part. More specifically, by the operation of the applying part, the microvibration is applied such that the second base part (in other words, the driven part supported by the second base part) rotates while resonating around the axis along the another direction at the resonance frequency determined by the inertia moment around the axis along the another direction of the suspended part including the second base part (more specifically, the suspended part which is a structure including the second base part for suspending the driven part and the suspended part which is a structure composed of the driven part, the second base part, and the second elastic part) and a torsion spring constant of the first elastic part. At the same time, the microvibration allows the driven part to rotate while resonating around the axis along the one direction at the resonance frequency determined by the second elastic part and the driven part. More specifically, the microvibration allows the driven part to rotate while resonating around the axis along the one direction at the resonance frequency determined by the inertia moment around the axis along the one direction of the driven part and a torsion spring constant of the second elastic part. In other words, in this aspect, the microvibration for performing the biaxial rotational drive of the driven part is applied from the same applying part (in other words, a single applying part).

Here, if the biaxial rotational drive of the driven part is performed by applying a so-called directional force (e.g. if the base part is greatly distorted or twisted along the rotational direction of the driven part and the distortion is directly applied to the elastic part and the driven part to perform the biaxial rotational drive of the driven part), one applying device needs to apply a directional force for rotating the driven part around the axis along the one direction (i.e. a directional force for distorting or twisting the structure such as the base part along the direction of the rotation around the axis along the one direction). Another applying device also needs to apply a directional force for rotating the driven part around the axis along the another direction (i.e. a directional force for distorting or twisting the structure such as the base part along the direction of the rotation around the axis along the another direction). That is, in the case where the biaxial rotational drive of the driven part is performed by applying the directional force, usually, the driving apparatus needs to be provided with two or more applying parts (in other words, two or more driving sources). In other words, in the case where the biaxial rotational drive of the driven part is performed by applying the directional force, only a force that acts along the one direction can be applied from one applying part, and thus, the driving apparatus needs to be provided with two or more applying parts (i.e. two or more driving sources).

In this aspect, however, the biaxial rotational drive of the driven part can be performed by applying the non-directional force caused by the microvibration. Here, since the non-directional force caused by the microvibration is applied, the microvibration applied from one applying part allows the driven part to rotate around the axis along the one direction and allows the driven part to rotate around the axis along the another direction, using the elasticity of the first and second elastic parts (i.e. the elasticity for rotating the driven part around the axis along the one direction and the elasticity for rotating the driven part around the axis along the another direction). In other words, in this aspect, even in the case of the biaxial rotational drive of the driven part, it is not always necessary to provide two applying parts. Thus, by using a single applying part (in other words, a single driving source), the microvibration for performing the biaxial rotational drive of the driven part can be applied.

In addition, even if a force acting along two directions can be applied from one applying part, in the case where the biaxial rotational drive of the driven part is performed by applying the directional force, it is eventually necessary to apply a force having components acting along the two directions (i.e. a directional component force for rotating the driven part around the axis along the one direction and a directional component force for rotating the driven part around the axis along the another direction). In this aspect, however, since the non-directional force caused by the microvibration is applied as the wave-energy, there is no need to apply the force in view of a direction of acting the force, which is also advantageous.

Incidentally, in the explanation described above, the suspended part which is a structure composed of the driven part, the second base part, and the second elastic part is explained as an example of the suspended part including the second base part. However, if other structures (e.g. magnetic poles, coils, comb-like or interdigitated electrodes, etc. described later) are provided for the second base part, the other structures also constitute the suspended part.

In this aspect, the applying part may apply, to the first base part, the microvibration for rotating the second base part such that the second base part rotates while resonating around the axis along the another direction at a resonance frequency determined by the first elastic part and the second base part and for rotating the driven part such that the driven part rotates while resonating around the axis along the one direction at the resonance frequency determined by the second elastic part and the driven part.

By virtue of such a configuration, the biaxial rotational drive of the driven part can be preferably performed by applying the microvibration to the first base part.

In another aspect of the driving apparatus in the embodiment, the driven part is divided into a plurality of driven portions, the elastic part comprises (i) a third elastic part which connects a first group of driven portions out of the plurality of driven portions and the base part and which has elasticity for rotating the first group of driven portions around an axis along at least one of the one direction and another direction which is different from the one direction and (ii) a fourth elastic part which connects a second group of driven portions, which is different from the first group of driven portions, out of the plurality of driven portions and the base part and which has elasticity for rotating the second group of driven portions around the axis along at least one of the one direction and the another direction, and the applying part applies the microvibration for rotating the first group of driven portions such that the first group of driven portions rotate while resonating around the axis along at least one of the one direction and the another direction at a resonance frequency determined by the third elastic part and the first group of driven portions and for rotating the second group of driven portions such that the second group of driven portions rotate while resonating around the axis along at least one of the one direction and the another direction at a resonance frequency determined by the fourth elastic part and the second group of driven portions.

According to this aspect, the driven part can be divided into the first group of driven portions which rotate while resonating at one resonance frequency and the second group of driven portions which rotate while resonating at another resonance frequency. Even in this case, since the non-directional force caused by the microvibration is applied, the microvibration allows the first group of driven portions to rotate around the axis along at least one of the one direction and the another direction using the elasticity of the third elastic part and allows the second group of driven portions to rotate around the axis along at least one of the one direction and the another direction using the elasticity of the fourth elastic part. Thus, even if the driven part is divided into the plurality of driven portions which rotate while resonating at different resonance frequencies around axes along different directions, each of the plurality of driven portions can be preferably rotated by using a single applying part.

In another aspect of the driving apparatus in the embodiment, the applying part is a single applying part.

According to this aspect, even in the case of the biaxial rotational drive of the driven part, it is not always necessary to provide two applying parts. Thus, by using a single applying part, the microvibration for performing the biaxial rotational drive of the driven part can be applied. Incidentally, it is obvious that multiaxial rotational drive which is biaxial or more may be performed.

In another aspect of the driving apparatus in the embodiment, the elastic part has elasticity for rotating the driven part around an axis along another direction which is different from the one direction, and the applying part applies each of (i) the microvibration for rotating the driven part such that the driven part rotates while resonating around the axis along the one direction at the resonance frequency determined by the elastic part and the driven part and (ii) a driving force for rotating the driven part such that the driven part rotates around the axis along the another direction.

According to this aspect, the driven part (more specifically, a structure for suspending the driven part and a structure composed of the driven part, the second base part, and the second elastic part detailed later) can be rotated around the axis along the another direction using the elasticity of the elastic part (more specifically, the first elastic part described later), and the driven part can be rotated around the axis along the one direction using the elasticity of the elastic part (more specifically, the second elastic part described later). Thus, as detailed using the drawings later, it is possible to preferably perform the biaxial rotational drive of the driven part.

In this aspect, in particular, the driven part does not need to resonate along the another direction whereas the driven part resonates along the one direction when the driven part is rotated, which is different from the above aspects of the driving apparatus in which the driven part resonates along each of the one direction and the another direction when the driven part is rotated. At this time, the applying part uses the non-directional force described above as the force for rotating the driven part around the axis along the one direction but does not need to use the non-directional force described above as the force for rotating the driven part around the axis along the another direction as the central axis. In other words, the applying part may use the non-directional force described above as the force for rotating the driven part around the axis along the one direction and may use the directional force described above (i.e. the force directly acting along the direction of rotating the driven part around the axis along the another direction) as the force for rotating the driven part around the axis along the another direction. Even in such a configuration, the biaxial rotational drive of the driven part can be preferably performed.

Incidentally, the non-directional force described above may be used in addition to the directional force described above, as the force for rotating the driven part around the axis along the another direction. In other words, a combination of the directional force and the non-directional force may be used to rotate the driven part around the axis along the another direction.

In another aspect of the driving apparatus in the embodiment, the base part comprises: a first base part; and a second base part surrounded by the first base part, the elastic part comprises: (i) a first elastic part which connects the first base part and the second base part and which has elasticity for rotating the second base part around the axis along the another direction; and (ii) a second elastic part which connects the second base part and the driven part and which has elasticity for rotating the driven part around the axis along the one direction, and the applying part applies each of (i) the microvibration for rotating the driven part such that the driven part rotates while resonating around the axis along the one direction at a resonance frequency determined by the second elastic part and the driven part and (ii) a driving force for rotating the second base part such that the second base part rotates around the axis along the another direction.

According to this aspect, the second base part can be rotated around the axis along the another direction by using the elasticity of the first elastic part, and the driven part can be rotated around the axis along the one direction by using the elasticity of the second elastic part. Here, since the driven part is connected to the second base part via the second elastic part, the rotation of the second base part around the axis along the another direction results in the rotation of the driven part around the axis along the another direction. Thus, as detailed using the drawings later, it is possible to preferably perform the biaxial rotational drive of the driven part.

In this aspect, in particular, the driven part does not need to resonate along the another direction whereas the driven part resonates along the one direction when the driven part is rotated, which is different from the above aspects of the driving apparatus in which the driven part resonates along each of the one direction and the another direction when the driven part is rotated. At this time, the applying part uses the non-directional force described above as the force for rotating the driven part around the axis along the one direction but does not need to use the non-directional force described above as the force for rotating the driven part around the axis along the another direction. In other words, the applying part may use the non-directional force described above as the force for rotating the driven part around the axis along the one direction and may use the directional force described above (i.e. the force directly acting along the direction of rotating the driven part around the axis along the another direction) as the force for rotating the driven part around the axis along the another direction. Even in such a configuration, the biaxial rotational drive of the driven part can be preferably performed.

In this aspect, the applying part may apply, to the second base part, each of (i) the microvibration for rotating the driven part such that the driven part rotates while resonating around the axis along the one direction at the resonance frequency determined by the second elastic part and the driven part and (ii) the driving force for rotating the second base part such that the second base part rotates around the axis along the another direction.

By virtue of such a configuration, the biaxial rotational drive of the driven part can be preferably performed by applying the microvibration and the driving force to the second base part.

These operation and other advantages in the embodiment will become more apparent from the examples explained below.

As explained above, according to the driving apparatus in the embodiment is provided with: the base part; the driven part; the elastic part; and the applying part. Therefore, the driven part can be rotated by using a force other than the directional force.

### Examples

Hereinafter, with reference to the drawings, examples of the driving apparatus will be explained. Incidentally, hereinafter, an explanation will be given to an example in which the driving apparatus is applied to a MEMS scanner.

### (1) First Example

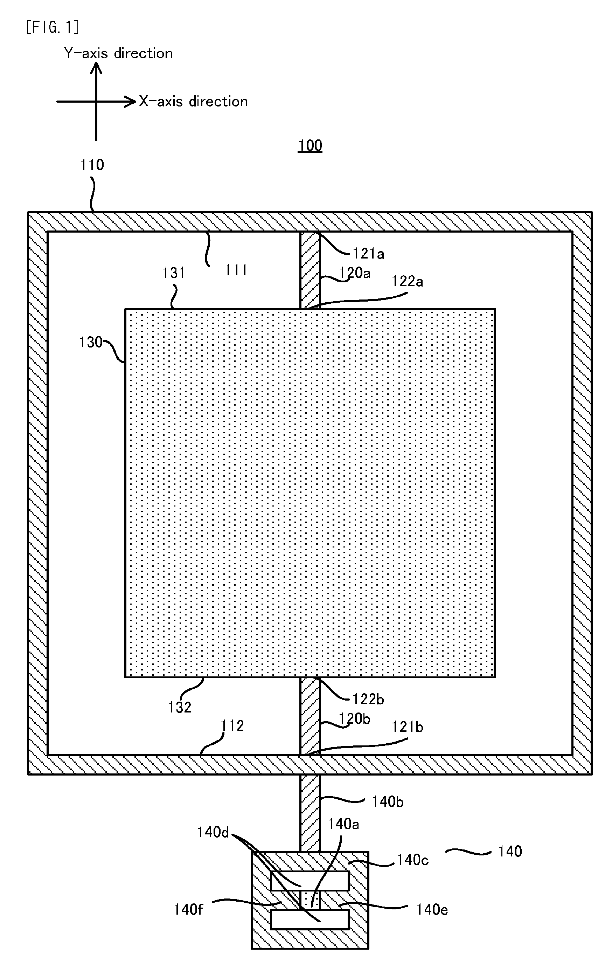

Firstly, with reference to FIG. 1 to FIG. 3, a first example of the MEMS scanner will be explained.

### (1-1) Basic Configuration

Firstly, with reference to FIG. 1, a basic configuration of a MEMS scanner 100 in the first example will be explained. FIG. 1 is a plan view conceptually showing the basic configuration of the MEMS scanner 100 in the first example.

As shown in FIG. 1, the MEMS scanner 100 in the first example is provided with: a base 110 which constitutes one specific example of the "base part" described above; torsion bars 120a and 120b which constitute one specific example of the "elastic part" described above; a mirror 130 which constitutes one specific example of the "driven part" described above; and a driving source part 140 which constitutes one specific example of the "applying part" described above.

The base 110 has a frame shape with a space therein. In other words, the base 110 has a frame shape having two sides extending along a Y-axis direction in FIG. 1 and two sides extending along an X-axis direction (i.e. an axial direction perpendicular to the Y-axis) in FIG. 1 and having a space surrounded by the two sides extending along the Y-axis direction and the two sides extending along the X-axis direction. In an example shown in FIG. 1, the base 110 has, but not limited to, a square shape. For example, the base 110 may have another shape (e.g. rectangular shape such as an oblong, a circular shape, etc.). Moreover, the base 110 is a structure which is the foundation of the MEMS scanner 100 in the first example and is preferably fixed to a not-illustrated substrate or support member (in other words, is fixed in the inside of a system which is the MEMS scanner 100).

Incidentally, FIG. 1 shows the example in which the base 110 has the frame shape, but obviously the base 110 may have another shape. For example, the base 110 may have a U-shape in which one portion of the sides is open. Alternatively, for example, the base 110 may have a box shape with a space therein. In other words, the base 110 may have a box shape having two surfaces distributed on a plane defined by the X-axis and the Y-axis, two surfaces distributed on a plane defined by the X-axis and a not-illustrated Z-axis (i.e. a Z axis perpendicular to both the X-axis and the Y-axis), and two surfaces distributed on a plane defined by the Y-axis and the not-illustrated Z-axis, and having a space surrounded by the six surfaces. Alternatively, the shape of the base 110 may be arbitrarily changed depending on an arrangement aspect of the mirror 130.

The torsion bar 120a is, for example, an elastic member such as a spring made of silicone, copper alloy, iron-based alloy, other metal, resin, or the like. The torsion bar 120a is disposed to extend along the Y-axis direction in FIG. 1. In other words, the torsion bar 120a has a shape having a long side extending along the Y-axis direction and a short side extending along the X-axis direction. However, in accordance with a setting situation of a resonance frequency described later, the torsion bar 120a may have a shape having a short side extending along the Y-axis direction and a long side extending along the X-axis direction. One end 121a of the torsion bar 120a is connected to a side 111 on the inner side of the base 110. The other end 122a of the torsion bar 120a is connected to a side 131 of the mirror opposed to the side 111 on the inner side of the base 110 in the Y-axis direction.

In the same manner, the torsion bar 120b is, for example, an elastic member such as a spring made of silicone, copper alloy, iron-based alloy, other metal, resin, or the like. The torsion bar 120b is disposed to extend along the Y-axis direction in FIG. 1. In other words, the torsion bar 120b has a shape having a long side extending along the Y-axis direction and a short side extending along the X-axis direction. However, in accordance with the setting situation of the resonance frequency described later, the torsion bar 120b may have a shape having a short side extending along the Y-axis direction and a long side extending along the X-axis direction. One end 121b of the torsion bar 120b is connected to a side 112 on the inner side of the base 110 opposed to the side (in other words, area portion) 111 on the inner side of the base 110 (i.e. the side 111 on the inner side of the base 110 to which the one end 121a of the torsion bar 120a is connected). The other end 122b of the torsion bar 120b is connected to a side 132 of the mirror 130 opposed to the side 112 on the inner side of the base 110 in the Y-axis direction.

The mirror 130 is disposed in the space in the inside of the base 110 so as to be hung or supported by the torsion bars 120a and 120b. The mirror 130 is configured to rotate around an axis along the Y-axis direction, by the elasticity of the torsion bars 120a and 120b.

The driving source part 140 applies, to the base 110, microvibration required to rotate the mirror 130 around an axis along the Y-axis direction. Incidentally, as long as the driving source part 140 can apply the microvibration to the base 110, its arrangement aspect may be determined arbitrarily. Moreover, it may be configured not only to apply a force to the base 110 but also to apply a force to other positions.

More specifically, the driving source part 140 is provided with: a piezoelectric element 140a; a transmission branch 140b; and a support plate 140c having a space 140d and fixed to the base 110 via the transmission branch 140b. On the support plate 140c, the piezoelectric element 140a is sandwiched between branches 140e and 140f facing to each other and defined by the space 140d. The application of a voltage to the piezoelectric element 140a via a not-illustrated electrode changes the shape of the piezoelectric element 140a. The change in the shape of the piezoelectric element 140a causes a change in the shapes of the branches 140e and 140f. As a result, the change in the shapes of the branches 140e and 140f is transmitted to the base 110 via the transmission branch 140b as the microvibration (or wave-energy) detailed later.

Incidentally, as the driving source part 140, not only a driving source part for applying microvibration caused by a piezoelectric effect, but also a driving source part for applying microvibration caused by an electromagnetic force and a driving source part for applying microvibration caused by an electrostatic force may be used. Of course, other methods may be also used.

The driving source part for applying the microvibration caused by the electromagnetic force is provided with: a magnetic pole disposed at the branch 140e; and a coil disposed at the branch 140f. In this case, a desired voltage is applied to the coil in desired timing from a not-illustrated driving source part control circuit. The application of the voltage to the coil causes an electric current to flow and causes an electromagnetic interaction between the coil and the magnetic pole. As a result, an electromagnetic force is generated by the electromagnetic interaction. The electromagnetic force causes the change in the shapes of the branches 140e and 140f. As a result, the change in the shapes of the branches 140e and 140f is transmitted to the base 110 via the transmission branch 140b as the microvibration (or pulsed energy) detailed later.

Moreover, the driving source part for applying the microvibration caused by the electrostatic force is provided with: a first comb-like (or interdigitated) electrode disposed at the branch 140e; and a second comb-like (or interdigitated) electrode disposed at the branch 140f and distributed in such a manner that the first electrode and the second electrode interdigitate each other. In this case, a desired voltage is applied to the first electrode in desired timing from a not-illustrated driving source part control circuit. Due to a potential difference between the first electrode and the second electrode, an electrostatic force (in other words, Coulomb force) is generated between the first electrode and the second electrode. The electrostatic force causes the change in the shapes of the branches 140e and 140f. As a result, the change in the shapes of the branches 140e and 140f is transmitted to the base 110 via the transmission branch 140b as the microvibration (or wave-energy) detailed later.

### (1-2) Operation of MEMS Scanner

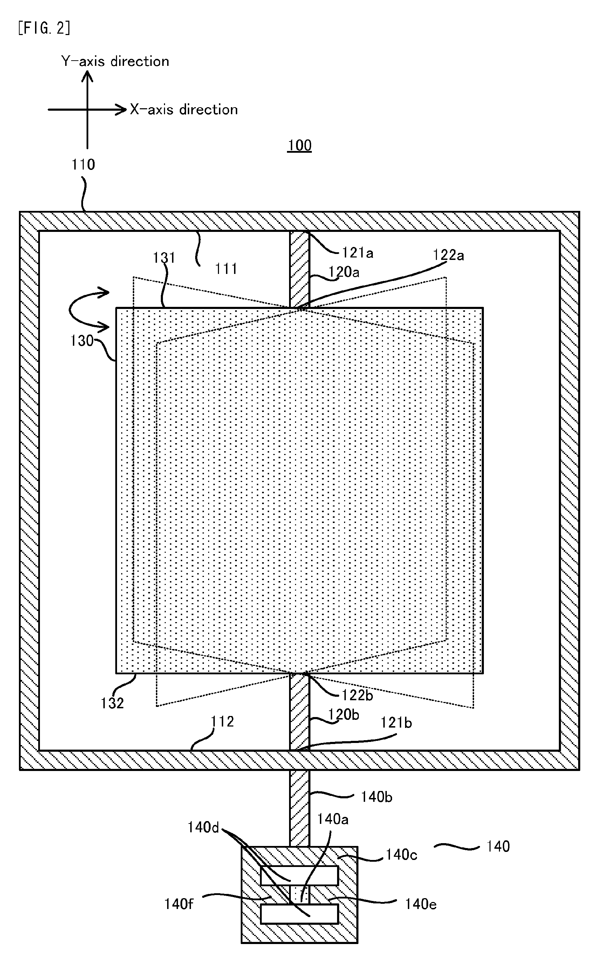

Next, with reference to FIG. 2, an explanation will be given to an aspect of the operation of the MEMS scanner 100 in the first example (specifically, an aspect of the operation of rotating the mirror 130). FIG. 2 is a plan view conceptually showing the aspect of the operation performed by the MEMS scanner 100 in the first example.

In operation of the MEMS scanner 100 in the first example, the driving source part 140 applies a voltage to the piezoelectric element 140a via a not-illustrated electrode such that the piezoelectric element 140a expands and contracts along the X-axis direction in FIG. 2. This changes the shape of the piezoelectric element 140a and changes the shapes of the branches 140e and 140f. As a result, the change in the shapes of the branches 140e and 140f is transmitted to the base 110 via the transmission branch 140b as the microvibration (or wave-energy) detailed later.

Here, since the change in the shape of the piezoelectric element 140a is along the X-axis direction in FIG. 2, the change in the shape of each of the branches 140e and 140f caused by the change in the shape of the piezoelectric element 140a occurs along the X-axis direction in FIG. 2. Here, the direction of a force caused by the change in the shape of the piezoelectric element 140a is different from a rotational direction of the mirror 130 (i.e. a direction of the rotation around the Y-axis direction). On the other hand, the change in the shape of the piezoelectric element 140a (i.e. the change in the shape of each of the branches 140e and 140f) is transmitted to the base 110 as the microvibration (in other words, wave-energy and a non-directional force) via the support plate 140c and the transmission branch 140b. More specifically, the driving source part 140 applies the microvibration, which is propagated in the inside of the base 110 while eliminating a distortion along a rotational direction of the base 110, as the wave-energy to the base 110 which is the foundation. In other words, the driving source part 140 applies the microvibration which is propagated as energy (in other words, as wave-energy for developing a force) in the inside of the base 110, instead of applying a force for providing the distortion along the rotational direction of the base 110. The microvibration becomes the non-directional force when being propagated in the inside of the base 110. In other words, the wave-energy propagated in the inside of the base 110 as the microvibration is propagated along an arbitrary direction in the inside of the base 110. Moreover, the base 110 to which the microvibration is applied becomes a medium for propagating the microvibration (in other words, the wave-energy) rather than an object in which the base 110 vibrates.

As a result, the microvibration applied from the driving source part 140 to the base 110 is transmitted from the base 110 to the torsion bars120a and 120b. Then, as shown in FIG. 2, the microvibration (in other words, the wave-energy) propagated in the inside of the base 110 rotates the torsion bars 120a and 120b along a direction according to the elasticity of the torsion bars 120a and 120b and rotates the mirror 130. In other words, the microvibration propagated in the inside of the base 110 appears as the rotation of the torsion bars 120a and 120b and the rotation of the mirror 130. In other words, the wave-energy can be extracted as vibration along all directions without limiting the direction of the microvibration. In other words, the wave-energy propagated in the inside of the base 110 can be extracted to the exterior in a form of vibration (more specifically, resonance), resulting in the rotation of the mirror 130. As a result, as shown in FIG. 2, the mirror 130 rotates around the axis along the Y-axis direction. More specifically, the mirror 130 repeats the rotation operation at a resonance frequency in a predetermined range of angles (in other words, repeats a reciprocating operation of the rotation in a predetermined range of angles). Incidentally, the wave-energy can be extracted to the exterior as a sound; however, the sound generated in this case has a different sound generation principle, in comparison with that of a sound obtained by a so-called piston motion.

At this time, the mirror 130 rotates so as to resonate at a resonance frequency determined in accordance with the mirror 130 and the torsion bars 120a and 120b. For example, if the inertia moment of the mirror 130 around the axis along the Y-axis is I and a torsion spring constant of the torsion bars 120a and 120b when the torsion bars 120a and 120b are regarded as one spring is k, then, the mirror 130 rotates around the axis along the Y-axis direction so as to resonate at a resonance frequency specified by (1/(2π))×√(k/I) (or a resonance frequency which is N multiple or 1/N multiple of (1/(2π))×√(k/I) (where N is an integral number of 1 or more)). Thus, the driving source part 140 applies the microvibration in an aspect of being synchronized with the resonance frequency described above such that the mirror 130 resonates at the resonance frequency described above.

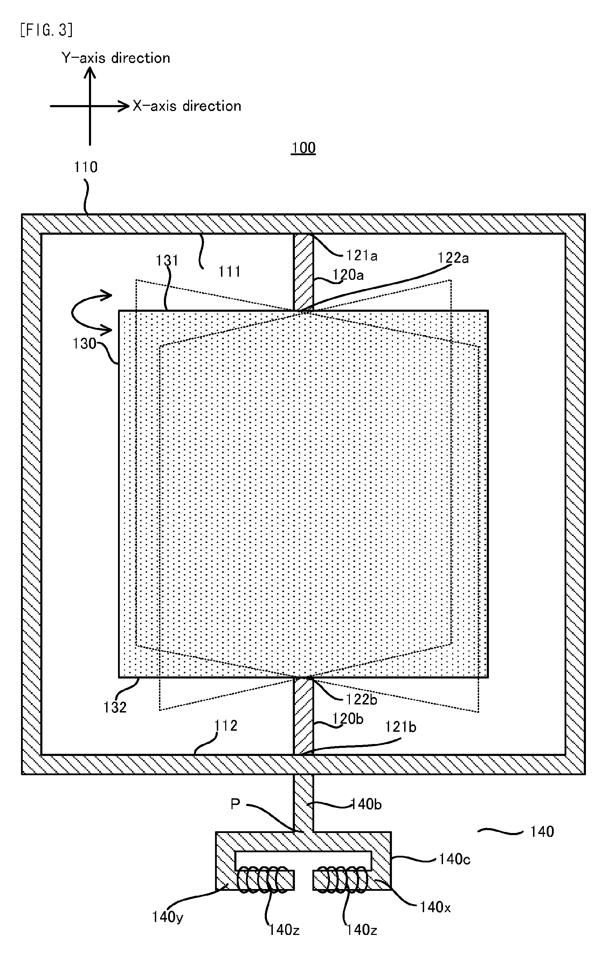

Now, with reference to FIG. 3, the non-directional force caused by the microvibration applied from the driving source part 140 will be further explained. FIG. 3 is a plan view for explaining the non-directional force caused by the microvibration applied from the driving source part 140. Incidentally, the following explanation uses a configuration in which the driving force part 140 applies the microvibration caused by the electromagnetic force.

As shown in FIG. 3, the driving source part 140 is provided with: the transmission branch 140b; the support plate 140c connected to a base 110 via the transmission branch 140b and provided with branches 140x and 140y facing to each other along the X-axis direction; and coils 140z which are wound around the branches 140x and 140y, respectively. Moreover, it is assumed that the branches 140x and 140y have the same shape and characteristics and that the characteristics (e.g. the number of turns) of the coil 140z which is wound around the branch 140x are the same as the characteristics (e.g. the number of turns) of the coil 140z which is wound around the branch 140y.

Here, in a case where an electric current is applied to the coils 140z which are wound around the branches 140x and 140y, if a force to be pulled toward the branch 140y (i.e. a force acting toward a negative direction of the X-axis, i.e., toward the left side in FIG. 3) is generated for the branch 140x due to the electromagnetic interaction, a force to be pulled toward the branch 140x (i.e. a force acting toward a positive direction of the X-axis, i.e., toward the right side in FIG. 3) is also generated for the branch 140y. The forces are opposed to each other and have the same magnitude. The forces thus do not cause acceleration in the exterior and thereon, and only the microvibration is transmitted to a point P of the junction of the branches 140x and 140y (in other words, a point P on the transmission branch 140b). As a result, a force at the point P is not directional. In the same manner, if a force to be separated from the branch 140y (i.e. a force acting toward the positive direction of the X-axis, i.e., toward the right side in FIG. 3) is generated for the branch 140x due to the electromagnetic interaction, a force to be separated from the branch 140x (i.e. a force acting toward the negative direction of the X-axis, i.e., toward the left side in FIG. 3) is also generated for the branch 140y. The forces are opposed to each other and have the same magnitude. The forces thus do not cause acceleration in the exterior and thereon, and only the microvibration is transmitted to the point P of the junction of the branches 140x and140y. As a result, a force at the points P is not directional.

However, according to experiments of the present inventors, it has been found that the microvibration (i.e. the wave-energy and the non-directional force) is propagated in the inside of the base 110 due to the aforementioned configuration, resulting in the rotation of the mirror 130 around the axis along the Y-axis direction. In other words, it has been found that the microvibration applied by the driving source part 140 is propagated in the inside of the base 110 as the non-directional force (in other words, the wave-energy) described above, by which the mirror 130 rotates around the axis along the Y-axis direction.

As described above, in the first example, the mirror 130 can be rotated around the axis along the Y-axis direction such that the mirror 130 resonates at the resonance frequency determined in accordance with the mirror 130 and the torsion bars 120a and 120b. In other words, in the first example, the mirror 130 self-resonates around the Y-axis.

Here, the "resonance" is a phenomenon in which the repetition of an infinitesimal force causes infinite displacement. Thus, even if a small force is applied in order to rotate the mirror 130, a rotation range of the mirror 130 (in other words, an amplitude along the rotational direction) can be set large. In other words, it is possible to set a force required to rotate the mirror 130 relatively small. It is thus possible to reduce the amount of electric power required to apply the force required to rotate the mirror 130. Therefore, it is possible to rotate the mirror 130 more efficiently, resulting in lower power consumption of the MEMS scanner 100.

In addition, in the first example, the non-directional force is applied.

Here, as a comparative example, a configuration in which the mirror 130 is driven so as to rotate by applying a so-called directional force (e.g. a configuration in which the base 110 is greatly distorted or twisted along the rotational direction of the mirror 130 and the distortion is directly applied to the torsion bars 120a and 120b and the mirror 130 to rotate the mirror 130) will be explained. In this case, the driving source part 140 needs to apply a directional force for rotating the mirror 130 around the axis along the Y-axis direction (i.e. a force for greatly distorting or twisting the base 110 around the axis along the Y-axis direction). Thus, the placement position of the driving source part 140 needs to be appropriately set such that the directional force can be applied. In other words, if the directional force is applied, the placement position of the driving source part 140 is limited depending on a direction of acting the force.

In the first example, however, since the non-directional force caused by the microvibration is applied, the placement position of the driving source part 140 is no longer limited. In other words, the application of the non-directional force caused by the microvibration does not cause such a situation that the placement position of the driving source part 140 is limited depending on the rotational direction of the mirror 30. That is, regardless of the placement position of the driving source part 140, the microvibration (i.e. the non-directional force) applied from the driving source part 140 allows the mirror 130 to rotate around the axis along the Y-axis direction, using the elasticity of the torsion bars 120a and 120b. This makes it possible to relatively increase the degree of freedom in the design of the MEMS scanner 100. This is extremely useful in practice for the MEMS scanner which is significantly limited in size or design of each constituent.

### (2) Second Example

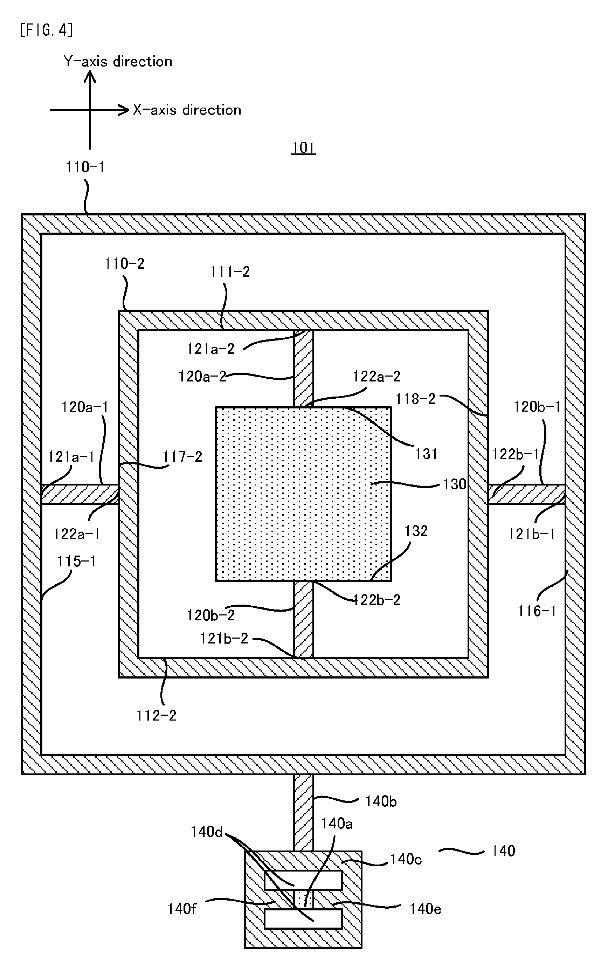

Firstly, with reference to FIG. 4 to FIGs. 7, a second example of the MEMS scanner will be explained.

### (2-1) Basic Configuration

Firstly, with reference to FIG. 4, a basic configuration of a MEMS scanner 101 in the second example will be explained. FIG. 4 is a plan view conceptually showing the basic configuration of the MEMS scanner 101 in the second example.

As shown in FIG. 4, the MEMS scanner 101 in the second example is provided with: a first base 110-1 which constitutes one specific example of the "base part (or first base part)" described above; a first torsion bar 120a-1 which constitutes one specific example of the "elastic part (or first elastic part)" described above; a first torsion bar 120b-1 which constitutes one specific example of the "elastic part (or first elastic part)" described above; a second base 110-2 which constitutes one specific example of the "base part (or second base part)" described above; a second torsion bar 120a-2 which constitutes one specific example of the "elastic part (or second elastic part)" described above; a second torsion bar 120b-2 which constitutes one specific example of the "elastic part (or second elastic part)" described above; a mirror 130 which constitutes one specific example of the "driven part" described above; and a driving source part 140 which constitutes one specific example of the "applying part" described above.

The first base 110-1 has a frame shape with a space therein. In other words, the first base 110-1 has a frame shape having two sides extending along the Y-axis direction in FIG. 4 and two sides extending along the X-axis direction (i.e. an axial direction perpendicular to the Y-axis) in FIG. 4 and having a space surrounded by the two sides extending along the Y-axis direction and the two sides extending along the X-axis direction. In an example shown in FIG. 4, the first base 110-1 has, but not limited to, a square shape. For example, the first base 110-1 may have another shape (e.g. rectangular shape such as an oblong, a circular shape, etc.). Moreover, the first base 110-1 is a structure which is the foundation of the MEMS scanner 101 in the second example and is preferably fixed to a not-illustrated substrate or support member (in other words, is fixed in the inside of a system which is the MEMS scanner 101).

Incidentally, FIG. 4 shows the example in which the first base 110-1 has the frame shape, but obviously the first base 110-1 may have another shape. For example, the first base 110-1 may have a U-shape in which one portion of the sides is open. Alternatively, for example, the first base 110-1 may have a box shape with a space therein. In other words, the first base 110-1 may have a box shape having two surfaces distributed on a plane defined by the X-axis and the Y-axis, two surfaces distributed on a plane defined by the X-axis and the not-illustrated Z-axis (i.e. the Z axis perpendicular to both the X-axis and the Y-axis), and two surfaces distributed on a plane defined by the Y-axis and the not-illustrated Z-axis, and having a space surrounded by the six surfaces. Alternatively, the shape of the first base 110-1 may be arbitrarily changed depending on an arrangement aspect of the mirror 130.

The first torsion bar 120a-1 is, for example, an elastic member such as a spring made of silicone, copper alloy, iron-based alloy, other metal, resin, or the like. The first torsion bar 120a-1 is disposed to extend along the X-axis direction in FIG. 4. In other words, the first torsion bar 120a-1 has a shape having a long side extending along the X-axis direction and a short side extending along the Y-axis direction. However, in accordance with a setting situation of a resonance frequency described later, the first torsion bar 120a-1 may have a shape having a short side extending along the X-axis direction and a long side extending along the Y-axis direction. One end 121a-1 of the first torsion bar 120a-1 is connected to a side 115-1 on the inner side of the first base 110-1. The other end 122a-1 of the first torsion bar 120a-1 is connected to a side 117-2 on the outer side of the second base 110-2 opposed to the side 115-1 on the inner side of the first base 110-1 in the X-axis direction.

In the same manner, the first torsion bar 120b-1 is, for example, an elastic member such as a spring made of silicone, copper alloy, iron-based alloy, other metal, resin, or the like. The first torsion bar 120b-1 is disposed to extend along the X-axis direction in FIG. 4. In other words, the first torsion bar 120b-1 has a shape having a long side extending along the X-axis direction and a short side extending along the Y-axis direction. However, in accordance with the setting situation of the resonance frequency described later, the first torsion bar 120b-1 may have a shape having a short side extending along the X-axis direction and a long side extending along the Y-axis direction. One end 121b-1 of the first torsion bar 120b-1 is connected to a side 116-1 on the inner side of the first base 110-1 opposed to the side (in other words, area portion) 115-1 on the inner side of the first base 110-1 in the X-axis direction (i.e. the side 115-1 on the inner side of the first base 110-1 to which the one end 121a-1 of the first torsion bar 120a-2 is connected). The other end 122b-1 of the first torsion bar 120b-1 is connected to a side 118-2 on the outer side of the second base 110-2 opposed to the side 116-1 on the inner side of the first base 110-1 in the X-axis direction.

The second base 110-2 has a frame shape with a space therein. In other words, the second base 110-2 has a frame shape having two sides extending along the Y-axis direction in FIG. 4 and two sides extending along the X-axis direction (i.e. the axial direction perpendicular to the Y-axis) in FIG. 4 and having a space surrounded by the two sides extending along the Y-axis direction and the two sides extending along the X-axis direction. In the example shown in FIG. 4, the second base 110-2 has, but not limited to, a square shape. For example, the second base 110-2 may have another shape (e.g. rectangular shape such as an oblong, a circular shape, etc.).

Moreover, the second base 110-2 is disposed in the space in the inside of the first base 110-1 so as to be hung or supported by the first torsion bars 120a-1 and 120b-1. The second base 110-2 is configured to rotate around an axis along the X-axis direction, by the elasticity of the first torsion bars 120a-1 and 120b-1.

Incidentally, FIG. 4 shows the example in which the second base 110-2 has the frame shape, but obviously the second base 110-2 may have another shape. For example, the second base 110-2 may have a U-shape in which one portion of the sides is open. Alternatively, for example, the second base 110-2 may have a box shape with a space therein. In other words, the second base 110-2 may have a box shape having two surfaces distributed on a plane defined by the X-axis and the Y-axis, two surfaces distributed on a plane defined by the X-axis and the not-illustrated Z-axis (i.e. the Z axis perpendicular to both the X-axis and the Y-axis), and two surfaces distributed on a plane defined by the Y-axis and the not-illustrated Z-axis, and having a space surrounded by the six surfaces. Alternatively, the shape of the second base 110-2 may be arbitrarily changed depending on the arrangement aspect of the mirror 130.

The second torsion bar 120a-2 is, for example, an elastic member such as a spring made of silicone, copper alloy, iron-based alloy, other metal, resin, or the like. The second torsion bar 120a-2 is disposed to extend along the Y-axis direction in FIG. 4. In other words, the second torsion bar 120a-2 has a shape having a long side extending along the Y-axis direction and a short side extending along the X-axis direction. However, in accordance with the setting situation of the resonance frequency described later, the second torsion bar 120a-2 may have a shape having a short side extending along the Y-axis direction and a long side extending along the X-axis direction. One end 121a-2 of the second torsion bar 120a-2 is connected to a side 111-2 on the inner side of the second base 110-2. The other end 122a-2 of the second torsion bar 120a-2 is connected to one side 131 of the mirror 130 opposed to the side 111-2 on the inner side of the second base 110-2 in the Y-axis direction.

In the same manner, the second torsion bar 120b-2 is, for example, an elastic member such as a spring made of silicone, copper alloy, iron-based alloy, other metal, resin, or the like. The second torsion bar 120b-2 is disposed to extend along the Y-axis direction in FIG. 4. In other words, the second torsion bar 120b-2 has a shape having a long side extending along the Y-axis direction and a short side extending along the X-axis direction. However, in accordance with the setting situation of the resonance frequency described later, the second torsion bar 120b-2 may have a shape having a short side extending along the Y-axis direction and a long side extending along the X-axis direction. One end 121b-2 of the second torsion bar 120b-2 is connected to a side 112-2 on the inner side of the second base 110-2 opposed to the side (in other words, area portion) 111-2 on the inner side of the second base 110-2 in the Y-axis direction (i.e. the side 111-2 on the inner side of the second base 110-2 to which the one end 121a-2 of the second torsion bar 120a-2 is connected). The other end 122b-2 of the second torsion bar 120b-2 is connected to other side 132 of the mirror 130 opposed to the side 112-2 on the inner side of the second base 110-2 in the Y-axis direction.

The mirror 130 is disposed in the space in the inside of the second base 110-2 so as to be hung or supported by the second torsion bars 120a-2 and 120b-2. The mirror 130 is configured to rotate around an axis along the Y-axis direction, by the elasticity of the second torsion bars 120a-2 and 120b-2.

The driving source part 140 applies, to the first base 110-1, microvibration required to rotate the second base 110-2 around the axis along the X-axis direction and required to rotate the mirror 130 around the axis along the Y-axis direction. Incidentally, as long as the driving source part 140 can apply the microvibration to the first base 110-1a, its arrangement aspect may be determined arbitrarily. Moreover, it may be configured not only to apply the microvibration to the first base 110-1 but also to apply the microvibration to other positions.

More specifically, the driving source part 140 is provided with: a piezoelectric element 140a; a transmission branch 140b; and a support plate 140c having a space 140d and fixed to the first base 110-1 via the transmission branch 140b. On the support plate 140c, the piezoelectric element 140a is sandwiched between branches 140e and 140f facing to each other and defined by the space 140d. The application of a voltage to the piezoelectric element 140a via a not-illustrated electrode changes the shape of the piezoelectric element 140a. The change in the shape of the piezoelectric element 140a causes a change in the shapes of the branches 140e and 140f. As a result, the change in the shapes of the branches 140e and 140f is transmitted to the first base 110-1 via the transmission branch 140b as the microvibration (or the wave-energy) detailed later.

Incidentally, as the driving source part 140, not only a driving source part for applying microvibration caused by a piezoelectric effect, but also a driving source part for applying microvibration caused by an electromagnetic force and a driving source part for applying microvibration caused by an electrostatic force may be used. Of course, other methods may be also used.

For example, the driving source part for applying the microvibration caused by the electromagnetic force is provided with: a magnetic pole disposed at the branch 140e; and a coil disposed at the branch 140f. In this case, a desired voltage is applied to the coil in desired timing from a not-illustrated driving source part control circuit. The application of the voltage to the coil causes an electric current to flow and causes an electromagnetic interaction between the coil and the magnetic pole. As a result, an electromagnetic force is generated by the electromagnetic interaction. The electromagnetic force causes the change in the shapes of the branches 140e and 140f. As a result, the change in the shapes of the branches 140e and 140f is transmitted to the first base 110-1 via the transmission branch 140b as the microvibration (or the wave-energy) detailed later.

Moreover, the driving source part for applying the microvibration caused by the electrostatic force is provided with: a first comb-like or interdigitated electrode disposed at the branch 140e; and a second comb-like or interdigitated electrode disposed at the branch 140fand distributed in such a manner that the first electrode and the second electrode interdigitate each other. In this case, a desired voltage is applied the first electrode in desired timing from a not-illustrated driving source part control circuit. Here, due to a potential difference between the first electrode and the second electrode, an electrostatic force (in other words, Coulomb force) is generated between the first electrode and the second electrode. The electrostatic force causes the change in the shapes of the branches 140e and 140f. As a result, the change in the shapes of the branches 140e and 140f is transmitted to the first base 110-1 via the transmission branch 140b as the microvibration (or the wave-energy) detailed later.

### (2-2) Operation of MEMS Scanner

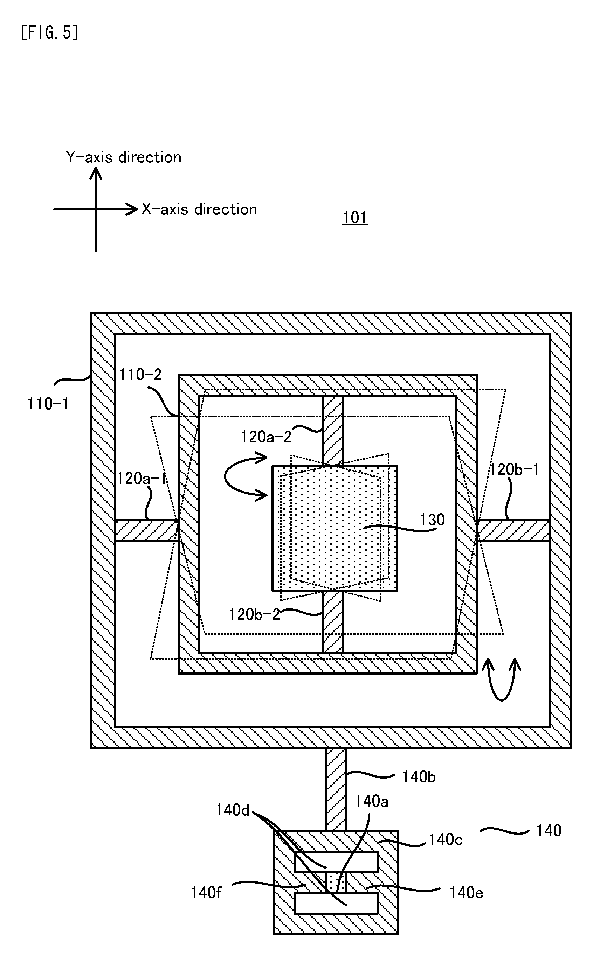

Next, with reference to FIG. 5, an explanation will be given to an aspect of the operation of the MEMS scanner 101 in the second example (specifically, an aspect of the operation of rotating the mirror 130). FIG. 5 is a plan view conceptually showing the aspect of the operation performed by the MEMS scanner 101 in the second example.

In operation of the MEMS scanner 101 in the second example, the driving source part 140 applies a voltage to the piezoelectric element 140a via a not-illustrated electrode such that the piezoelectric element 140a expands and contracts along the X-axis direction in FIG. 5. This changes the shape of the piezoelectric element 140a and changes the shapes of the branches 140e and 140f. As a result, the change in the shapes of the branches 140e and 140f is transmitted to the first base 110-1 via the transmission branch 140b as vibration energy instead of vibration detailed later.

Here, since the change in the shape of the piezoelectric element 140a is along the X-axis direction in FIG. 5, the change in the shape of each of the branches 140e and 140f caused by the change in the shape of the piezoelectric element 140a occurs along the X-axis direction in FIG. 5. Here, the direction of a force caused by the change in the shape of the piezoelectric element 140a is different from each of a rotational direction of the second base 110-2 (i.e. a direction of the rotation around the X-axis direction) and a rotational direction of the mirror 130 (i.e. a direction of the rotation around the Y-axis direction). On the other hand, the change in the shape of the piezoelectric element 140a (i.e. the change in the shape of each of the branches 140e and 140f) is transmitted to the first base 110-1 as the microvibration (in other words, the wave-energy and a non-directional force) via the support plate 140c and the transmission branch 140b. More specifically, the driving source part 140 applies the microvibration, which is propagated in the inside of the first base 110-1 while eliminating a distortion along a rotational direction of the first base 110-1), as the wave-energy to the first base 110-1 which is the foundation. In other words, the driving source part 140 applies the microvibration which is propagated as energy (in other words, as energy for developing a force) in the inside of the first base 110-1, instead of applying a force for providing the distortion along the rotational direction of the first base 110-1. The microvibration becomes the non-directional force when being propagated in the inside of the first base 110-1. In other words, the wave-energy propagated in the inside of the first base 110-1 as the microvibration is propagated along an arbitrary direction in the inside of the first base 110-1. Moreover, the first base 110-1 to which the microvibration is applied becomes a medium for propagating the microvibration (in other words, the wave-energy) rather than an object in which the first base 110-1 vibrates.

As a result, the microvibration applied from the driving source part 140 to the first base 110-1 is transmitted from the first base 110-1 to the first torsion bars 120a-1 and 120b-1. Then, as shown in FIG. 5, the microvibration (in other words, the wave-energy) propagated in the inside of the first base 110-1 rotates the first torsion bars 120a-1 and 120b-1 along a direction according to the elasticity of the first torsion bars 120a-1 and 120b-1 and rotates the second base 110-2. In other words, the microvibration propagated in the inside of the first base 110-1 appears as the rotation of the first torsion bars 120a-1 and 120b-1 and the rotation of the second base 110-2. In other words, the wave-energy can be extracted as vibration along all directions without limiting the direction of the microvibration. In other words, the wave-energy propagated in the inside of the first base 110-1 can be extracted to the exterior in a form of vibration (more specifically, resonance), resulting in the rotation of the second base 110-2 for supporting the mirror 130. As a result, as shown in FIG. 5, the second base 110-2 can be rotated around the axis along the X-axis direction. More specifically, the second base 110-2 repeats the rotation operation at a resonance frequency in a predetermined range of angles (in other words, repeats a reciprocating operation of the rotation in a predetermined range of angles).

At this time, the second base 110-2 rotates so as to resonate at a resonance frequency determined in accordance with a suspended part including the second base 110-2 (in other words, a suspended part including the second base 110-2 which is suspended by the first torsion bars 120a-1 and 120b-1) and the first torsion bars 120a-1 and 120b-1. For example, if the inertia moment, which is around the axis along the X-axis, of the suspended part including the second base 110-2 (more specifically, the inertia moment, which is around the axis along the X-axis, of the suspended part composed of an entire system which is the second base 110-2, to which the mass of each of the mirror 130 and the second torsional bars 120a-2 and 120b-2 provided in the second base 110-2 is added) is I1 and a torsion spring constant of the first torsion bars 120a-1 and 120b-1 when the first torsion bars 120a-1 and 120b-1 are regarded as one spring is k1, then, the second base 110-2 rotates around the axis along the X-axis direction so as to resonate at a resonance frequency specified by (1/(2π))×√(k1/I1) (or a resonance frequency which is N multiple or 1/N multiple of (1/(2π))×√(k1/I1) (where N is an integral number of 1 or more)). Thus, the driving source part 140 applies the microvibration in an aspect of being synchronized with the resonance frequency described above such that the second base 110-2 resonates at the resonance frequency described above.

In the same manner, the microvibration applied from the driving source part 140 to the first base 110-1 is transmitted from the first base 110-1, via the first torsion bars 120a-1 and 120b-1 and the second base 110-2, to the second torsion bars 120a-2 and 120b-2. Then, as shown in FIG. 5, the microvibration (in other words, the wave-energy) propagated in the inside of the first base 110-1 rotates the second torsion bars 120a-2 and 120b-2 along a direction according to the elasticity of the second torsion bars 120a-2 and 120b-2 and rotates the mirror 130. In other words, the microvibration propagated in the inside of the first base 110-1 appears as the rotation of the second torsion bars 120a-2 and 120b-2 and the rotation of the mirror 130. In other words, the pulsed energy can be extracted as vibration in all directions without limiting the direction of the microvibration. In other words, the wave-energy propagated in the inside of the first base 110-1 and the second base 110-2 can be extracted to the exterior in a form of vibration (more specifically, resonance), resulting in the rotation of the mirror 130. As a result, as shown in FIG. 5, the mirror 130 rotates around the axis along the Y-axis direction. More specifically, the mirror 130 repeats the rotation operation at a resonance frequency in a predetermined range of angles (in other words, repeats a reciprocating operation of the rotation in a predetermined range of angles).

At this time, the mirror 130 rotates so as to resonate at a resonance frequency determined in accordance with the mirror 130 and the second torsion bars 120a-2 and 120b-2. For example, if the inertia moment of the mirror 130 around the axis along the Y-axis is I2 and a torsion spring constant of the second torsion bars 120a-2 and 120b-2 when the second torsion bars 120a-2 and 120b-2 are regarded as one spring is k2, then, the mirror 130 rotates around the axis along the Y-axis direction so as to resonate at a resonance frequency specified by (1/(2π))×√(k2/I2) (or a resonance frequency which is N multiple or 1/N multiple of (1/(2π))×√(k2/I2) (where N is an integral number of 1 or more)). Thus, the driving source part 140 applies the microvibration in an aspect of being synchronized with the resonance frequency described above such that the mirror 130 resonates at the resonance frequency described above.

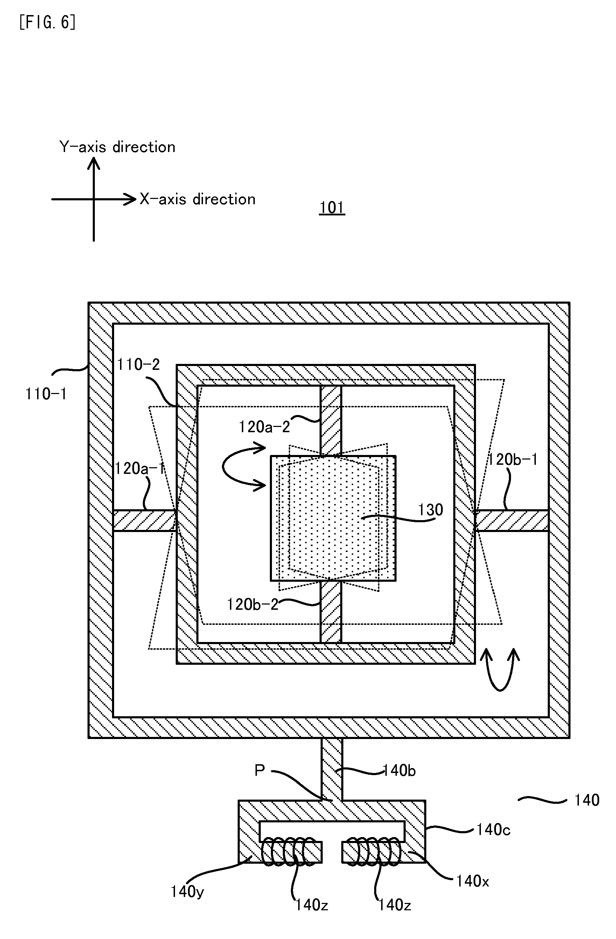

Now, with reference to FIG. 6, the non-directional force caused by the microvibration applied from the driving source part 140 will be further explained. FIG. 6 is a plan view for explaining the non-directional force caused by the microvibration applied from the driving source part 140. Incidentally, the following explanation uses a configuration in which the driving force part 140 applies the microvibration caused by the electromagnetic force.

As shown in FIG. 6, the driving source part 140 is provided with: the transmission branch 140b; the support plate 140c connected to the first base 110-1 via the transmission branch 140b and provided with branches 140x and 140y facing to each other along the X-axis direction; and coils 140z which are wound around the branches 140x and 140y, respectively. Moreover, it is assumed that the branches 140x and 140y have the same shape and characteristics and that the characteristics (e.g. the number of turns) of the coil 140z which is wound around the branch 140x are the same as the characteristics (e.g. the number of turns) of the coil 140z whichi s wound around the branch 140y.

Here, in a case where an electric current is applied to the coils 140z which are wound around the branches 140x and 140y, if a force to be pulled toward the branch 140y (i.e. a force acting toward a negative direction of the X-axis, i.e., toward the left side in FIG. 6) is generated for the branch 140x due to the electromagnetic interaction, a force to be pulled toward the branch 140x (i.e. a force acting toward a positive direction of the X-axis, i.e., toward the right side in FIG. 6) is also generated for the branch 140y. The forces are opposed to each other and have the same magnitude. The forces thus do not cause acceleration in the exterior and thereon, and only the microvibration is transmitted to a point P of the junction of the branches 140x and 140y (in other words, a point P on the transmission branch 140b). As a result, a force at the point P is not directional. In the same manner, if a force to be separated from the branch 140y (i.e. a force acting toward the positive direction of the X-axis, i.e., toward the right side in FIG. 6) is generated for the branch 140x due to the electromagnetic interaction, a force to be separated from the branch 140x (i.e. a force acting toward the negative direction of the X-axis, i.e., toward the left side in FIG. 6) is also generated for the branch 140y. The forces are opposed to each other and have the same magnitude. The forces thus do not cause acceleration in the exterior and thereon, and only the microvibration is transmitted to the point P of the junction of the branches 140x and 140y. As a result, a force at the point P is not directional.

However, according to the experiments of the present inventors, it has been found that the microvibration (i.e. the wave-energy and the non-directional force) is propagated in the inside of the first base 110-1 due to the aforementioned configuration, resulting in the rotation of the second base 110-2 around the axis along the X-axis direction and the rotation of the mirror 130 around the axis in the Y-axis direction. In other words, it has been found that the microvibration applied by the driving source part 140 is propagated in the inside of the first base 110-1 as the non-directional force (in other words, the wave-energy) described above, by which the second base 110-2 rotates around the axis along the X-axis direction and the mirror 130 rotates around the axis along the Y-axis direction.

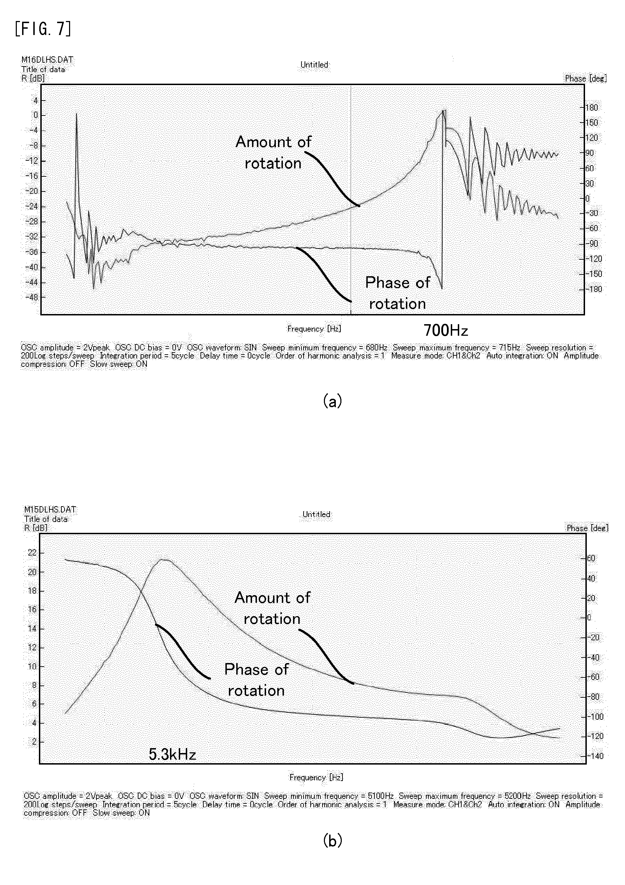

Moreover, graphs from actual experimental results will be explained with reference to FIGs. 7. FIGs. 7 are graphs showing the experimental results. Incidentally, in the experiments, the mirror 130 with a size of "3 mm×4 mm" is used, the resonance frequency of the second base 110-2 is set to 700 Hz, and the resonance frequency of the mirror 130 is set to 5.3 kHz. Incidentally, it does not intend that the present invention is not limited to the configuration having those numerical values.

FIG. 7(a) shows an aspect of the rotation of the second base 110-2 around the axis along the X-axis direction. A horizontal axis of FIG. 7(a) indicates frequency of a signal applied to the driving source part 140, and vertical axes of FIG. 7(a) indicate an amount of rotation (left side) and a phase of rotation (right side) of the second base 110-2. As is clear from the graph shown in FIG. 7(a), if the frequency of the signal applied to the driving source part 140 changes, the amount of rotation of the second base 110-2 is maximal and the phase of rotation is reversed at a time point at which the repetition frequency of the signal is "700 Hz". This indicates that the second base 110-2 rotates around the axis along the X-axis direction while resonating at a frequency of "700 Hz". In other words, it is confirmed by the experiments that the second base 110-2 rotates around the axis along the X-axis direction while resonating at a frequency of "700 Hz, by applying the non-directional force caused by the microvibration.

FIG. 7(b) shows an aspect of the rotation of the mirror 130 around the axis along the Y-axis direction. A horizontal axis of FIG. 7(b) indicates frequency of a signal applied to the driving source part 140, and vertical axes of FIG. 7(b) indicate an amount of rotation (left side) and a phase of rotation (right side) of the mirror 130. As is clear from the graph shown in FIG. 7(b), if the frequency of the signal applied to the driving source part 140 changes, the amount of rotation of the mirror 130 is maximal and the phase of rotation is reversed at a time point at which the repetition frequency of the signal is "5.3 kHz". This indicates that the mirror 130 rotates around the axis along the Y-axis direction while resonating at a frequency of "5.3 kHz". In other words, it is confirmed by the experiments that the mirror 130 rotates around the axis along the Y-axis direction while resonating at a frequency of "5.3 kHz, by applying the non-directional force caused by the microvibration.

As described above, in the second example, the mirror 130 can be rotated around the axis along the Y-axis direction such that the mirror 130 resonates at the resonance frequency determined in accordance with the mirror 130 and the second torsion bars 120a-2 and 120b-2, and the second base 110-2 can be rotated around the axis along the X-axis direction such that the second base 110-2 resonates at the resonance frequency determined in accordance with the second base 110-2 and the first torsion bars 120a-1 and 120b-1. Here, considering that the mirror 130 is connected to the second base 110-2 via the second torsion bars 120a-2 and 120b-2, with the rotation of the second base 110-2 around the axis along the X-axis direction, the mirror 130 also rotates around the axis along the X-axis direction. As a result, the mirror 130 can be rotated such that the mirror 130 resonates around each of the X-axis and the Y-axis. In other words, in the second example, the mirror 130 self-resonates around each of the X-axis and the Y-axis.

Here, the "resonance" is a phenomenon in which the repetition of an infinitesimal force causes infinite displacement. Thus, even if a small force is applied in order to rotate the mirror 130, a rotation range of the mirror 130 (in other words, an amplitude along the rotational direction) can be set large. In other words, it is possible to set the force required to rotate the mirror 130 relatively small. It is thus possible to reduce the amount of electric power necessary to apply the force required to rotate the mirror 130. Therefore, it is possible to rotate the mirror 130 more efficiently, resulting in lower power consumption of the MEMS scanner 101.

In addition, in the second example, the non-directional force is applied.

Here, as a comparative example, a configuration in which biaxial rotational drive of the mirror 130 is performed by applying a so-called directional force (e.g. a configuration in which the first base 110-1 is greatly distorted or twisted and the distortion is directly applied to the first torsion bars 120a-1 and 120b-1, the second torsion bars 120a-2 and 120b-2, and the mirror 130 to perform the biaxial rotational drive of the mirror 130) will be explained. In this case, one driving source part 140 needs to apply a directional force for rotating the mirror 130 around the axis along the X-axis direction (i.e. a directional force for distorting or twisting the first base 110-1 around the axis along the X-axis direction). Another driving source part 140 also needs to apply a directional force for rotating the mirror 130 around the axis along the Y-axis direction (i.e. a directional force for distorting or twisting the first base 110-1 around the axis along the Y-axis direction). That is, in the case where the biaxial rotational drive of the mirror 130 is performed by applying the directional force, the MEMS scanner needs to be provided with two or more driving source parts 140. In other words, in the case where the biaxial rotational drive of the mirror 130 is performed by applying the directional force, since only a force that acts along one direction can be applied from one driving source part 140, and thus, the MEMS scanner needs to be provided with two or more driving source parts 140.

In the second example, however, the biaxial rotational drive of the mirror 130 can be performed by applying the non-directional force caused by the microvibration. Here, since the non-directional force caused by the microvibration is applied, the microvibration (i.e. the non-directional force) applied from one driving source part 140 allows the mirror 130 to rotate around each of the axis along the X-axis direction and the axis along the Y-axis direction, using the elasticity of the first torsion bars 120a-1 and 120b-1 (i.e. the elasticity for rotating the second base 110-2, which supports the mirror 130, around the axis along the X-axis direction) and the elasticity of the second torsion bars 120a-2 and 120b-2 (i.e. the elasticity for rotating the mirror 130 around the axis along the Y-axis direction). In other words, in the second example, even in the case of the biaxial rotational drive of the mirror 130, it is not always necessary to provide two driving source parts 140. Thus, by using a single driving source part 140, the non-directional force caused by the microvibration for performing the biaxial rotational drive of the mirror 130 can be applied.

In addition, even if a force acting along two directions can be applied from one driving source part, in the case where the biaxial rotational drive of the mirror 130 is performed by applying the directional force, it is eventually necessary to apply a force having components acting along the two directions (i.e. a directional component force for rotating the mirror 130 around the axis along the X-axis direction and a directional component force for rotating the mirror 130 around the axis along the Y-axis direction). In the second example, however, since the non-directional force caused by the microvibration is applied as the pulsed energy, there is no need to apply the force in view of a direction of acting the force, which is also advantageous.

In addition, since the non-directional force caused by the microvibration is applied, the placement position of the driving source part 140 is no longer limited. In other words, the application of the non-directional force caused by the microvibration does not cause such a situation that the placement position of the driving source part 140 is limited depending on the rotational direction of the mirror 130. That is, regardless of the placement position of the driving source part 140, the non-directional force caused by the microvibration applied from the driving source part 140 allows the mirror 130 to rotate around the axis along each of the X-axis direction and the Y-axis direction, using the elasticity of the first torsion bars 120a-1 and 120b-1 and the elasticity of the second torsion bars 120a-2 and 120b-2. This makes it possible to relatively increase the degree of freedom in the design of the MEMS scanner 101. This is extremely useful in practice for the MEMS scanner which is significantly limited in size or design of each constituent.

### (3) Third Example

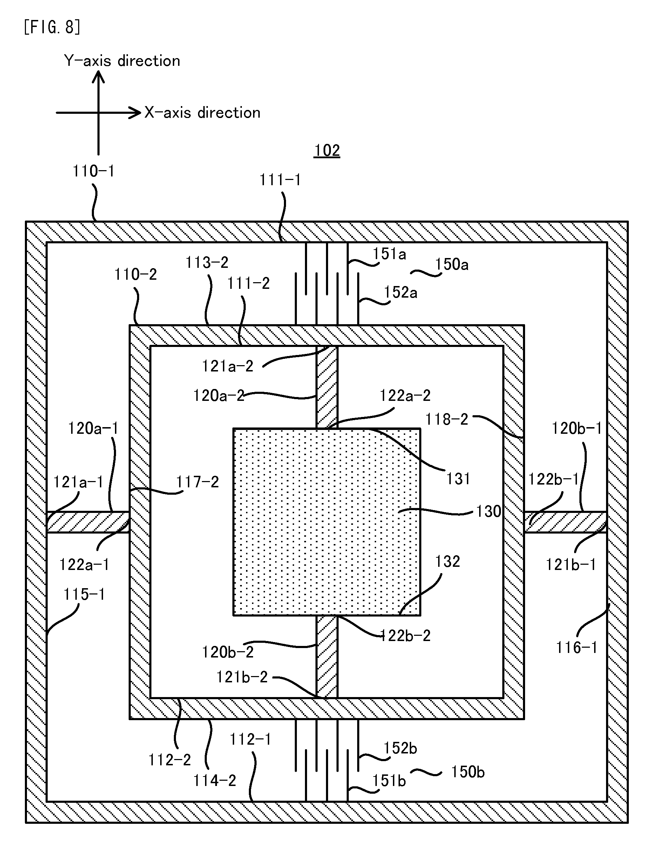

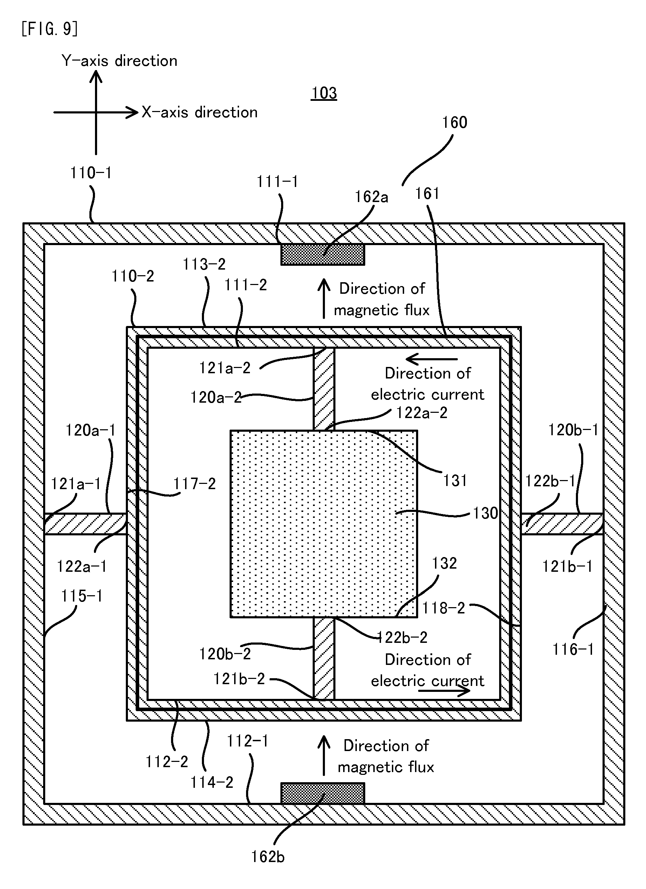

Next, with reference to FIG. 8 and FIG. 9, a third example of the MEMS scanner will be explained. FIG. 8 is a plan view conceptually showing a basic configuration of a MEMS scanner 102 having one configuration in the third example. FIG. 9 is a plan view conceptually showing a basic configuration of a MEMS scanner 103 having another configuration in the third example. Incidentally, the same constituents as those of the MEMS scanner 100 in the first example and the MEMS scanner 101 in the second example described above will carry the same reference numerals, and the detailed explanation thereof will be omitted.

As shown in FIG. 8, the first MEMS scanner 102 in the third example is provided with: a first base 110-1; a first torsion bar 120a-1; a first torsion bar 120b-1; a second base 110-2; a second torsion bar 120a-2; a second torsion bar 120b-2; a mirror 130; and a driving source part 150, as in the MEMS scanner 101 in the second example.

The first MEMS scanner 102 in the third example is different from the MEMS scanner 101 in the second example particularly in the placement position of the driving source part 150. Specifically, in the first MEMS scanner 102 in the third example, the driving source part 150 is disposed so as to apply a force to the second base 110-2. More specifically, the driving source part 150 provided for the first MEMS scanner 102 in the third example is provided with two driving source parts 150a and 150b between which there is the mirror 130. The driving source part 150a is a driving source part for applying a force caused by an electrostatic force and is provided with: a first comb-like (or interdigitated) electrode 151a disposed on a side 111-1 on the inner side of the first base 110-1; and a second comb-like (or interdigitated) electrode 152a disposed on a side 113-2 on the outer side of the second base 110-2 and distributed in such a manner that the first electrode 151a and the second electrode 152a interdigitate each other. Moreover, the driving source part 150b is a driving source part for applying a force caused by an electrostatic force and is provided with: a first comb-like (or interdigitated) electrode 151b disposed on a side 112-1 on the inner side of the first base 110-1; and a second comb-like (or interdigitated) electrode 152b disposed on a side 114-2 on the outer side of the second base 110-2 and distributed in such a manner that the first electrode 151b and the second electrode 152b interdigitate each other.

Each of the driving source parts 150a and 150b in the third example applies, to the second base 110-2, a force required to rotate the second base 110-2 around the axis along the X-axis direction. In particular, each of the driving source parts 150a and 150b applies, to the second base 110-2, a force for relatively greatly vibrating the second base 110-2 in order to rotate the second base 110-2. More specifically, if a voltage is applied to each of the first electrodes 151a and 151b and the second electrodes 152a and 152b, electrostatic forces pulling against each other are generated between the first electrode 151a and the second electrode 152a and between the first electrode 151b and the second electrode 152b. The electrostatic forces act on the second base 110-2 as forces directed to a front side from a rear side or to the rear side from the front side of the sheet of FIG. 8. As a result, the second base 110-2 vibrates relatively greatly, thereby rotating around the axis along the X-axis direction. In other words, each of the driving source parts 150a and 150b directly applies, to the second base 110-2, the force for rotating the second base 110-2 around the axis along the X-axis direction (i.e. a directional force), thereby rotating the second base 110-2 around the axis along the X-axis direction. At the same time, each of the driving source parts 150a and 150b uses the force for rotating the second base 110-2 around the axis along the X-axis direction, thereby rotating the mirror 130 around the axis along the Y-axis direction. In other words, the mirror 130 rotates around the axis along the Y-axis direction, by using the force for rotating the second base 110-2 around the axis along the X-axis direction. Here, the electrostatic forces generated between the first electrode 151a and the second electrode 152a and between the first electrode 151b and the second electrode 152b have directivity to rotate the second base 110-2 around the axis along the X-axis direction at the generation time point thereof, but do not have directivity to rotate the mirror 130 around the axis along the Y-axis direction. Therefore, if the force for rotating the second base 110-2 around the axis along the X-axis direction is used to rotate the mirror 130 around the axis along the Y-axis direction, the force corresponds to the non-directional force described above.

In order to realize the operation as described above, to each of the driving source parts 150a and 150b, a signal obtained by superimposing a signal synchronized with a resonance frequency when the mirror 130 is rotated around the axis along the Y-axis direction (i.e. a voltage signal for generating microvibration) on a signal (i.e. a voltage signal) for generating the force for rotating the second base 110-2 around the axis along the X-axis direction is applied as an input signal.

Thus, according to the first MEMS scanner 102 in the third example, the directional force is used to rotate the mirror 130 (in other words, the second base 110-2 for supporting the mirror 130) around the axis along the X-axis direction while the non-directional force is used to rotate the mirror 130 around the axis along the Y-axis direction. Even in such a configuration, the biaxial rotational drive of the mirror 130 can be preferably performed.

As shown in FIG. 9, the second MEMS scanner 103 in the third example is provided with: a first base 110-1; a first torsion bar 120a-1; a first torsion bar 120b-1; a second base 110-2; a second torsion bar 120a-2; a second torsion bar 120b-2; a mirror 130; and a driving source part 160, as in the MEMS scanner 101 in the second example.

The second MEMS scanner 103 in the third example is different from the MEMS scanner 101 in the second example particularly in the placement position of the driving source part 160. Specifically, in the second MEMS scanner 103 in the third example, the driving source part 160 is disposed so as to apply a force to the second base 110-2. In other words, the placement position of the driving source part 160 in the second MEMS scanner 103 in the third example is the same as the placement position of the driving source part 150 in the first MEMS scanner 102 in the third example. The second MEMS scanner 103 in the third example is different from the first MEMS scanner 102 in the third example in that the configuration of the driving source part 160 is different. More specifically, the driving source part 160 provided for the second MEMS scanner 103 in the third example is a driving source part for applying a force caused by an electrostatic force and is provided with: a coil 161 disposed along the frame shape of the second base 110-2; a magnetic pole 162a disposed on a side 111-1 on the inner side of the first base 110-1; and a magnetic pole 162b disposed on a side 112-1 on the inner side of the first base 110-1.

The driving source part 160 in the third example applies, to the second base 110-2, a force required to rotate the second base 110-2 around the axis along the X-axis direction. In particular, the driving source part 160 applies, to the second base 110-2, a force for relatively greatly vibrating the second base 110-2 in order to rotate the second base 110-2. More specifically, for example, it is assumed that an electric current is applied to the coil 161 counterclockwise in FIG. 9, that a magnetic flux directed to an upper side from a lower side in FIG. 9 is generated from the magnetic pole 162a, and that a magnetic flux directed to the upper side from the lower side in FIG. 9 is generated from the magnetic pole 162b. In this case, a force acting to a rear side from a front side of the sheet of FIG. 9 is applied to upper sides 111-2 and 113-2 on the upper side of the coil 161 (i.e. upper sides 111-2 and 113-2on the second base 110-2 on which the coil 161 is disposed). In the same manner, a force acting to the front side from the rear side of the sheet of FIG. 9 is applied to lower sides 112-2 and 114-2 on the lower side of the coil 161 (i.e. lower sides 112-2 and 114-2 on the second base 110-2 on which the coil 161 is disposed). As a result, the second base 110-2 rotates around the axis along the X-axis direction. The forces applied at this time are forces directly acting so as to rotate the second base 110-2 around the axis along the X-axis direction and are the directional forces described above. At the same time, the driving source part 160 rotates the mirror 130 around the axis along the Y-axis direction, by using the force for rotating the second base 110-2 around the axis along the X-axis direction. In other words, the mirror 130 rotates around the axis along the Y-axis direction, by using the force for rotating the second base 110-2 with the axis in the X-axis direction as the central axis. Here, the electromagnetic forces generated in the coil 161 have directivity to rotate the second base 110-2 around the axis along the X-axis direction at the generation time point thereof, but do not have directivity to rotate the mirror 130 around the axis along the Y-axis direction. Therefore, if the force for rotating the second base 110-2 around the axis along the X-axis direction is used to rotate the mirror 130 around the axis along the Y-axis direction, the force corresponds to the non-directional force described above.

Thus, according to the second MEMS scanner 103 in the third example, the directional force is used to rotate the mirror 130 (in other words, the second base 110-2 for supporting the mirror 130) around the axis along the X-axis direction while the non-directional force is used to rotate the mirror 130 around the axis along the Y-axis direction. Even in such a configuration, the biaxial rotational drive of the mirror 130 can be preferably performed.

Incidentally, in the third example, the directional force is used to rotate the mirror 130 around the axis along the X-axis direction while the non-directional force is used to rotate the mirror 130 around the axis along the Y-axis direction. However, both the directional force and the non-directional force may be used to rotate the mirror 130 around the axis along the X-axis direction. In other words, in order to rotate the mirror 130 around a predetermined axis, only the non-directional force may be used, only the directional force may be used, and a combination of the directional force and the non-directional force may be used.

### (4) Fourth Example

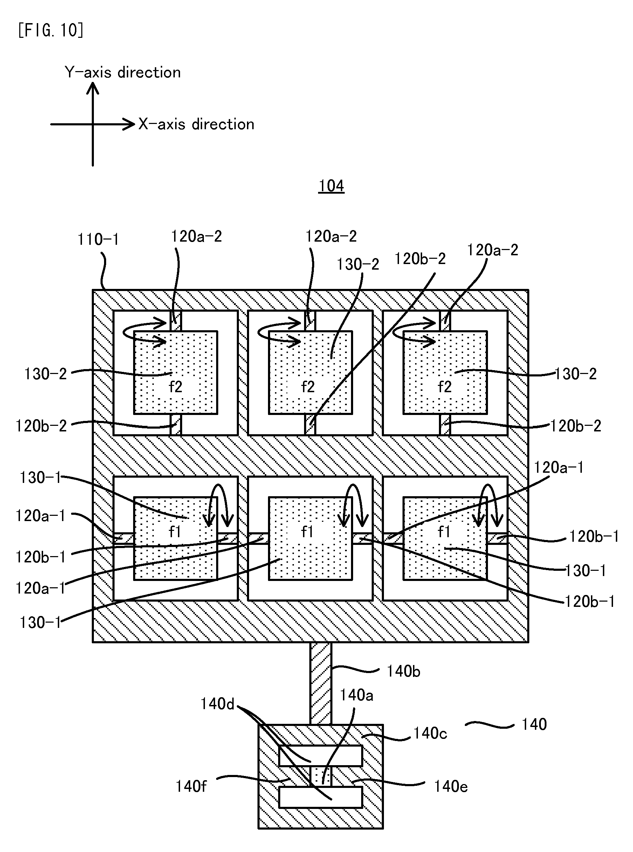

Next, with reference to FIG. 10, a fourth example of the MEMS scanner will be explained. FIG. 10 is a plan view conceptually showing a basic configuration of a MEMS scanner 104 in the fourth example. Incidentally, the same constituents as those of the MEMS scanner 100 in the first example and the MEMS scanner 101 in the second example described above will carry the same reference numerals, and the detailed explanation thereof will be omitted.

As shown in FIG. 10, the MEMS scanner 104 in the fourth example is provided with: a first base 110-1; and a driving source part 140, as in the MEMS scanner 101 in the second example.

The MEMS scanner 104 in the fourth example is particularly provided with: a plurality of mirrors 130-1 each of which is configured to rotate around the axis along the X-axis direction; a plurality of mirrors 130-2 each of which is configured to rotate around the axis along the Y-axis direction; a plurality of torsion bars 120a-1 and 120b-1 each of which connects the first base 110-1 and the corresponding mirror 130-1 out of the plurality of mirrors 130-1; and a plurality of torsion bars 120a-2 and 120b-2 each of which connects the first base 110-1 and the corresponding mirror 130-2 out of the plurality of mirrors 130-2. The MEMS scanner 104 in the fourth example corresponds to a configuration obtained by dividing the mirror 130 provided for the MEMS scanner 101 in the second example.

Each of the plurality of torsion bars 120a-1 and 120b-1 has the same configuration and characteristics as those of the first torsion bars 120a-1 and 120b-1 described above. Each of the plurality of torsion bars 120a-1 and 120b-1 is connected to the first base 110-1 at one end and connected to the corresponding mirror 130-1 at the other end. Moreover, each of the plurality of torsion bars 120a-1 and 120b-1 has elasticity for rotating the corresponding mirror 130-1 around the axis along the X-axis direction.

Each of the plurality of torsion bars 120a-2 and 120b-2 has the same configuration and characteristics as those of the second torsion bars 120a-2 and 120b-2 described above. Each of the plurality of torsion bars 120a-2 and 120b-2 is connected to the first base 110-1 at one end and connected to the corresponding mirror 130-2 at the other end. Moreover, each of the plurality of torsion bars 120a-2 and 120b-2 has elasticity for rotating the corresponding mirror 130-2 around the axis along the Y-axis direction.

Each of the plurality of mirrors 130-1 has substantially the same configuration as that of the mirror 130 described above, and it is disposed in a space in the inside of the first base 110-1 so as to be hung or supported by the corresponding torsion bars 120a-1 and 120b-1. Moreover, each of the plurality of mirrors 130-1 is set to have a resonance frequency of "f1". In other words, the inertia moment of each of the plurality of mirrors 130-1 around the axis along the X-axis direction and the torsion spring constant of each of the plurality of torsion bars 120a-1 and 120b-1 are set such that each of the plurality of mirrors 130-1 has a resonance frequency of "f1". Moreover, each of the plurality of mirrors 130-1 is configured to rotate around the axis along the X-axis direction by the elasticity of the torsion bars 120a-1 and 120b-1.

Each of the plurality of mirrors 130-2 has substantially the same configuration as that of the mirror 130 described above, and it is disposed in a space in the inside of the first base 110-1 so as to be hung or supported by the corresponding torsion bars 120a-2 and 120b-2. Moreover, each of the plurality of mirrors 130-2 is set to have a resonance frequency of "f2". In other words, the inertia moment of each of the plurality of mirrors 130-2 around the axis along the Y-axis direction and the torsion spring constant of each of the plurality of torsion bars 120a-2 and 120b-2 are set such that each of the plurality of mirrors 130-2 has a resonance frequency of "f2". Moreover, each of the plurality of mirrors 130-2 is configured to rotate around the axis along the Y-axis direction by the elasticity of the torsion bars 120a-2 and 120b-2.

The MEMS scanner 104 as described above can be used, for example, as a display apparatus. Specifically, the plurality of mirrors 130-1 are used as mirrors for performing vertical scanning by reflecting light from a light source. In the example shown in FIG. 10, three mirrors 130-1 preferably correspond to red (R), green (G), and blue (B). In the same manner, the plurality of mirrors 130-2 are used as mirrors for performing horizontal scanning by reflecting light from the light source. In the example shown in FIG. 10, three mirrors 130-2 preferably correspond to red (R), green (G), and blue (B).

According to the MEMS scanner 104 in the fourth example having such a configuration, since microvibration (i.e. non-directional force) is applied from the driving source part 140 to the first base 110-1, a non-directional force caused by the microvibration allows each of the plurality of mirrors 130-1 to rotate around the axis along the X-axis direction while resonating at one resonance frequency f1 using the elasticity of each of the plurality of torsion bars 120a-1 and 120b-1 and allows each of the plurality of mirrors 130-2 to rotate around the axis along the Y-axis direction while resonating at another resonance frequency f2 using the elasticity of each of the plurality of torsion bars 120a-2 and 120b-2. More specifically, by supplying the driving source part 140 with a signal obtained by superimposing a signal synchronized with the one resonance frequency f1 and a signal synchronized with the another resonance frequency f2, it is possible to rotate the plurality of mirrors 130-1 while resonating at the one resonance frequency f1 and it is possible to rotate the plurality of mirrors 130-2 while resonating at the another resonance frequency f2. In other words, the supply of only the signal synchronized with the one resonance frequency f1 to the driving source part 140 allows the plurality of mirrors 130-1 to rotate while resonating at the one resonance frequency f1 but does not allow the plurality of mirrors 130-2 to rotate. In the same manner, the supply of only the signal synchronized with the another resonance frequency f2 to the driving source part 140 allows the plurality of mirror 130-2 to rotate while resonating at the another resonance frequency f2 but does not allow the plurality of mirrors 130-1 to rotate. Thus, even if the MEMS scanner 104 is provided with the plurality of mirrors 130-1 and 130-2 having different resonance frequencies, each of the plurality of mirrors 130-1 and 130-2 can be preferably rotated by using a single driving source part 140.

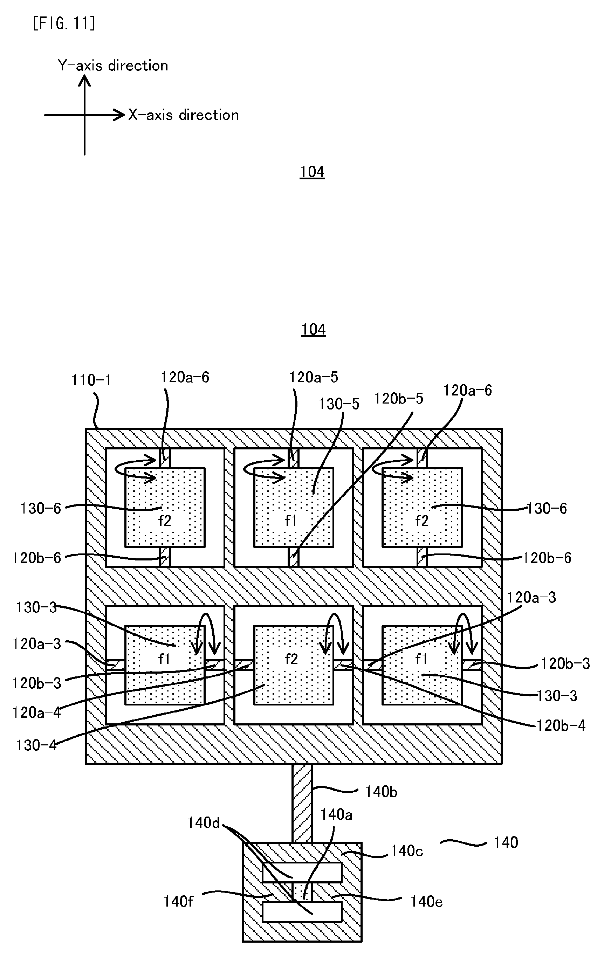

Incidentally, in the aforementioned example, it is explained that each of the plurality of mirrors 130-1 having a resonance frequency of f1 is rotated around the axis along the X-axis direction and each of the plurality of mirrors 130-2 having a resonance frequency of f2 is rotated around the axis along the Y-axis direction. However, it may be configured such that each of the plurality of mirrors 130 having a resonance frequency of f1 is rotated around the axis along the X-axis direction, that each of the plurality of mirrors 130 having a resonance frequency of f1 is rotated around the axis along the Y-axis direction, that each of the plurality of mirrors 130 having a resonance frequency of f2 is rotated around the axis along the X-axis direction, and that each of the plurality of mirrors 130 having a resonance frequency of f2 is rotated around the axis along the Y-axis direction. For example, as shown in FIG. 11, there may be provided: a plurality of first mirrors 130-3 which rotate around the axis along the X-axis direction while resonating at the one resonance frequency f1; a plurality of second mirrors 130-4 which rotate around the axis along the X-axis direction while resonating at the another resonance frequency f2; a plurality of third mirrors 130-5 which rotate around the axis along the Y-axis direction while resonating at the one resonance frequency f1; and a plurality of fourth mirrors 130-6 which rotate around the axis along the Y-axis direction while resonating at the another resonance frequency f2. In this case, by supplying the driving source part 140 with the signal obtained by superimposing the signal synchronized with the one resonance frequency f1 and the signal synchronized with the another resonance frequency f2, it is possible to rotate the plurality of first mirrors 130-3 around the axis along the X-axis direction while resonating at the one resonance frequency f1 and to rotate the plurality of third mirrors 130-5 around the axis along the Y-axis direction as the central axis while resonating at the one resonance frequency f1, and it is possible to rotate the plurality of second mirrors 130-4 around the axis along the X-axis direction while resonating at the another resonance frequency f2 and to rotate the plurality of fourth mirrors 130-6 around the axis along the Y-axis direction while resonating at the another resonance frequency f2. In other words, the supply of only the signal synchronized with the one resonance frequency f1 to the driving source part 140 allows the plurality of first mirrors 130-3 to rotate around the axis along the X-axis direction while resonating at the one resonance frequency f1 and allows the plurality of third mirrors 130-5 to rotate around the axis along the Y-axis direction while resonating at the one resonance frequency f1 but neither allow the plurality of second mirrors 130-4 to rotate around the axis along the X-axis direction while resonating at the another resonance frequency f2 nor allow the plurality of fourth mirrors 130-6 to rotate around the axis along the Y-axis direction while resonating at the another resonance frequency f2. In the same manner, the supply of only the signal synchronized with the another resonance frequency f2 to the driving source part 140 allows the plurality of second mirrors 130-4 to rotate around the axis along the X-axis direction while resonating at the another resonance frequency f2 and allows the plurality of fourth mirrors 130-6 to rotate around the axis along the Y-axis direction while resonating at the one resonance frequency f1 but neither allow the plurality of first mirrors 130-3 to rotate around the axis along the X-axis direction while resonating at the one resonance frequency f1 nor allow the plurality of third mirrors 130-5 to rotate around the axis along the Y-axis direction as the central axis while resonating at the one resonance frequency f1.

Even if the MEMS scanner 104 is provided with the plurality of mirrors 130-3 to 130-6 having different resonance frequencies and displacement directions as in this configuration, a desired mirror out of the plurality of mirrors 130-3 to 130-6 can be preferably rotated by using a single driving source part 140.

Incidentally, it is obvious that the various configurations explained in the first example to the third example described above may be applied to the MEMS scanner 104 in the fourth example described above, as occasion demands.

In the present invention, various changes may be made, if desired, without departing from the essence or spirit of the invention which can be read from the claims and the entire specification. A driving apparatus, which involves such changes, is also intended to be within the technical scope of the present invention.

### Description of Reference Codes

- 100: MEMS scanner
- 110: base
- 120: torsion bar
- 130: mirror
- 140: driving source part

## Claims

1. A driving apparatus comprising:
a base part;
a driven part capable of rotating;
an elastic part which connects the base part and the driven part and which has elasticity for rotating the driven part around an axis along one direction; and
an applying part for applying, to the base part, microvibration for rotating the driven part such that the driven part rotates while resonating around the axis along the one direction, at a resonance frequency determined by the elastic part and the driven part.

2. The driving apparatus according to claim 1, wherein the microvibration is non-direcitonal microvibration or anisotropic microvibration as non-directional vibration energy.

3. The driving apparatus according to claim 1, wherein the applying part applies the microvibration which is caused by a force acting along a direction that is different from a direction of the rotation around the axis along the one direction.

4. The driving apparatus according to claim 1, wherein the applying part applies the microvibration which is caused by a force acting along a direction along a surface of the driven part which is in a static condition.

5. The driving apparatus according to claim 1, wherein
the elastic part has elasticity for rotating the driven part around an axis along another direction which is different from the one direction, and
the applying part applies, to the base part, the microvibration for rotating the driven part such that the driven part rotates while resonating around the axis along the one direction at the resonance frequency determined by the elastic part and the driven part and for rotating the driven part such that the driven part rotates while resonating around the axis along the another direction at a resonance frequency determined by the elastic part and a suspended part including the driven part.

6. The driving apparatus according to claim 5, wherein
the base part comprises: a first base part; and a second base part at least partially surrounded by the first base part,
the elastic part comprises: (i) a first elastic part which connects the first base part and the second base part and which has elasticity for rotating the second base part around the axis along the another direction; and (ii) a second elastic part which connects the second base part and the driven part and which has the elasticity for rotating the driven part around the axis along the one direction, and
the applying part applies the microvibration for rotating the second base part such that the second base part rotates while resonating around the axis along the another direction at a resonance frequency determined by the first elastic part and a suspended part including the second base part and for rotating the driven part such that the driven part rotates while resonating around the axis along the one direction at a resonance frequency determined by the second elastic part and the driven part.

7. The driving apparatus according to claim 6, wherein the applying part applies, to the first base part, the microvibration for rotating the second base part such that the second base part rotates while resonating around the axis along the another direction at a resonance frequency determined by the first elastic part and the second base part and for rotating the driven part such that the driven part rotates while resonating around the axis along the one direction at the resonance frequency determined by the second elastic part and the driven part.

8. The driving apparatus according to claim 1, wherein
the driven part is divided into a plurality of driven portions,
the elastic part comprises (i) a third elastic part which connects a first group of driven portions out of the plurality of driven portions and the base part and which has elasticity for rotating the first group of driven portions around an axis along at least one of the one direction and another direction which is different from the one direction and (ii) a fourth elastic part which connects a second group of driven portions, which is different from the first group of driven portions, out of the plurality of driven portions and the base part and which has elasticity for rotating the second group of driven portions around an axis along at least one of the one direction and the another direction, and
the applying part applies the microvibration for rotating the first group of driven portions such that the first group of driven portions rotate while resonating around the axis along at least one of the one direction and the another direction at a resonance frequency determined by the third elastic part and the first group of driven portions and for rotating the second group of driven portions such that the second group of driven portions rotate while resonating around the axis along at least one of the one direction and the another direction at a resonance frequency determined by the fourth elastic part and the second group of driven portions.

9. The driving apparatus according to claim 1, wherein the applying part is a single applying part.

10. The driving apparatus according to claim 1, wherein
the elastic part has elasticity for rotating the driven part around an axis along another direction which is different from the one direction, and
the applying part applies each of (i) the microvibration for rotating the driven part such that the driven part rotates while resonating around the axis along the one direction at the resonance frequency determined by the elastic part and the driven part and (ii) a driving force for rotating the driven part such that the driven part rotates around the axis along the another direction.

11. The driving apparatus according to claim 10, wherein
the base part comprises: a first base part; and a second base part surrounded by the first base part,
the elastic part comprises: (i) a first elastic part which connects the first base part and the second base part and which has elasticity for rotating the second base part around the axis along the another direction; and (ii) a second elastic part which connects the second base part and the driven part and which has elasticity for rotating the driven part around the axis along the one direction, and
the applying part applies each of (i) the microvibration for rotating the driven part such that the driven part rotates while resonating around the axis along the one direction at a resonance frequency determined by the second elastic part and the driven part and (ii) a driving force for rotating the second base part such that the second base part rotates around the axis along the another direction.

12. The driving apparatus according to claim 11, wherein the applying part applies, to the second base part, each of (i) the microvibration for rotating the driven part such that the driven part rotates while resonating around the axis along the one direction at the resonance frequency determined by the second elastic part and the driven part and (ii) the driving force for rotating the second base part such that the second base part rotates around the axis along the another direction.
